(19) Europäisches Patentamt
European Patent Office
Office européen des brevets

(11) **EP 4 168 859 B1**

(12) **EUROPEAN PATENT SPECIFICATION**

(45) Date of publication and mention
of the grant of the patent:
**10.07.2024  Bulletin 2024/28**

(21) Application number: **21752678.9**

(22) Date of filing: **30.07.2021**

(51) International Patent Classification (IPC):
*G03F 9/00* *(2006.01)*      *G03F 1/74* *(2012.01)*
*G03F 1/86* *(2012.01)*

(52) Cooperative Patent Classification (CPC):
**G03F 9/7015; G03F 1/74; G03F 1/86;**
**G03F 9/7026; G03F 9/7034; G03F 9/7046**

(86) International application number:
**PCT/EP2021/071439**

(87) International publication number:
**WO 2022/023546 (03.02.2022 Gazette 2022/05)**

(54) **METHOD AND DEVICE FOR DETERMINING AN ALIGNMENT OF A PHOTOMASK ON A SAMPLE STAGE WHICH IS DISPLACEABLE ALONG AT LEAST ONE AXIS AND ROTATABLE ABOUT AT LEAST ONE AXIS**

VERFAHREN UND VORRICHTUNG ZUR BESTIMMUNG EINER AUSRICHTUNG EINER PHOTOMASKE AUF EINEM UM MINDESTENS EINE ACHSE DREHBAREN PROBENTISCH

PROCÉDÉ ET DISPOSITIF POUR DÉTERMINER UN ALIGNEMENT D'UN PHOTOMASQUE SUR UNE PLATINE D'ÉCHANTILLON POUVANT ÊTRE DÉPLACÉE LE LONG D'AU MOINS UN AXE ET POUVANT TOURNER AUTOUR D'AU MOINS UN AXE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **30.07.2020   DE 102020209638**

(43) Date of publication of application:
**26.04.2023   Bulletin 2023/17**

(60) Divisional application:
**24174102.4 / 4 390 538**

(73) Proprietor: **Carl Zeiss SMT GmbH**
**73447 Oberkochen (DE)**

(72) Inventors:
• **BAUR, Christof**
**64285 Darmstadt (DE)**
• **SIELAFF, Tilo**
**64295 Darmstadt (DE)**
• **ADAMS, Arne**
**65193 Wiesbaden (DE)**

(74) Representative: **Bardehle Pagenberg**
**Partnerschaft mbB**
**Patentanwälte Rechtsanwälte**
**Prinzregentenplatz 7**
**81675 München (DE)**

(56) References cited:
**JP-A- 2013 102 053      JP-B2- 6 548 764**
**US-A- 5 672 885         US-A1- 2005 285 033**
**US-A1- 2019 095 740**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present patent application claims the priority of the German patent application DE 10 2020 209 638.4, entitled "Verfahren und Vorrichtung zum Bestimmen einer Aus-richtung einer Fotomaske auf einem Probentisch, der entlang zumindest einer Achse verschiebbar und zumindest um eine Achse drehbar ist", which was filed at the German Patent and Trade Mark Office on 30 July 2020.

## 1. Technical field

The present invention relates to a method and a device for determining an alignment of a photomask on a sample stage which is displaceable along at least one axis and rotatable about at least one axis. In particular, the present invention relates to a method and a device for determining an alignment of a photomask on a sample stage which is displaceable along at least one axis that is parallel to a chuck surface, and is rotatable about at least one axis that is perpendicular to the chuck surface of the sample stage.

## 2. Prior art

As a consequence of the growing integration density in the semiconductor industry, photolithography masks have to image increasingly smaller structures on wafers. Producing the small structure dimensions imaged onto the wafer requires photolithographic masks or templates for nanoimprint lithography with ever smaller structures or pattern elements. The process for producing photolithographic masks and templates for nanoimprint lithography is therefore becoming increasingly more complex and thus more time-consuming and ultimately also more expensive. On account of the tiny structure sizes of the pattern elements of photolithographic masks or templates, faults during mask or template production cannot be ruled out. These must be repaired - whenever possible.

Faults or defects of photolithographic masks, photomasks, exposure masks, or just masks, are often repaired by providing one or more process or precursor gases at the repair location and scanning the defect with an electron beam, for example. The electron beam usually induces a local chemical reaction which, depending on the precursor gas used, results in a local etching process that can be used to remove locally excess material from the photomasks or a template for nanoimprint lithography. Alternatively, in the presence of a corresponding precursor gas, the electron beam induces a local chemical deposition reaction that deposits material locally on the photomask and thus replaces locally missing material of the mask.

A further cause of defects of photolithographic masks is particles that arise for instance as a result of the handling of the mask and deposit on the mask. These particles that disturb the imaging of the mask must likewise be removed from the mask. Disturbing particles can be removed from the photomask firstly with the aid of a local particle beam-induced etching process. Furthermore, it is possible to use a micromanipulator, for example in the form of a scanning probe microscope, in order to remove excess material, for instance particles present on the mask, from the photomask by means of mechanical processing of the particle.

On account of the increasingly smaller structures of photomasks and the decreasing actinic wavelength with which masks are exposed, ever smaller defects and/or ever smaller particles are having a disturbing effect on the imaging behaviour of photomasks. In this regard, in the case of masks for the extreme ultraviolet (EUV) wavelength range, for instance, the actinic wavelength is in a range of approximately 10 nm to 15 nm. This means that ever better tools for processing defects of photolithographic masks are required. Furthermore, this development has the consequence that the requirements in respect of the precision with which identified defects must be able to be approached for repair purposes are likewise increasing.

Documents US 2019/095740 A1, US 2005/285033 A1 and US 5 672 885 A disclose photomask inspection devices.

Owing firstly to the increasing requirements in respect of precision and secondly to extended possibilities for movement of the sample stage, the exact alignment or calibration of a mask in relation to the sample stage or the mask plate is becoming increasingly more complex and more costly. As a result, the alignment or the calibration of a mask to be repaired on a sample stage is increasingly influencing the repair times of defective masks. As a result, said repair times are becoming longer or the throughput of masks to be repaired is becoming lower.

Therefore, the problem addressed by the present invention is that of specifying a method and a device which improve the determining of an alignment of a photomask.

## 3. Summary of the invention

In accordance with one exemplary embodiment of the present invention, this problem is at least partly solved by means of the subjects of the independent claims of the present application. Exemplary embodiments are described in the dependent claims.

A first embodiment relates to a method for determining an alignment of a photomask on a sample stage which is displaceable along at least one axis that is parallel to a chuck surface of the sample stage, and is rotatable about at least one axis that is perpendicular to the chuck surface. The method comprises the following step: rotating the sample stage by a predefined angle and measuring a height change of the photomask during rotation at a predetermined, non-vanishing distance with respect to the rotation axis for the purpose of determining the alignment of the photomask on the sample stage.

A sample stage for a photomask typically has three translation axes that are perpendicular to one another. A sample stage which carries a photomask to be repaired, and which is not just displaceable in three directions, but rather is additionally rotatable about an axis perpendicular to the surface of the sample stage, extends the possibilities of defect repair by virtue of the fact that a defect can be imaged and/or processed from different sides. Moreover, defects having specific contours can be tracked to a processing location by means of a combined rotational and translational movement in a simpler form, compared with movements composed of two mutually perpendicular displacements.

The inventors have discovered, however, that a rotation of the sample stage about the z-axis perpendicular to the chuck surface can result in a height change at a processing location situated outside the rotation axis. The height change of the photomask is caused by a rotation axis that is not aligned perpendicular to the surface of the mask. A rotation axis that is not perpendicular to the mask results in a wobble movement of the photomask during the rotation thereof. As a result, the tool processing a defect can be positioned incorrectly in the z-direction, i.e. perpendicular to the chuck surface. In the worst case, as a result, during a rotational movement of the sample stage, a repair tool may damage a non-defective mask location as a result of unintended mechanical contact.

The method according to the invention determines the height change caused by a rotation of the sample stage at a defect processing location on the photomask. The defect processing location can be localized at any desired position on the mask. As a result, the method according to the invention fully exploits the improved defect repair possibilities resulting from the rotatable sample stage. Moreover, the method according to the invention avoids unintended damage to a photomask during a rotation process.

The sample stage can be rotated by an angle that is greater than or equal to: 60°, preferably 90°, more preferably 180°, and most preferably 360°.

As the rotation angle increases, there is an increase in the accuracy with which it is possible to determine the height change or a height profile of the photomask during rotation. It is therefore advantageous to choose the rotation angle to be as large as possible, i.e. approximately 360°. Rotations with an even greater rotation angle merely improve the data recording statistics.

A photomask can comprise a transmissive photomask or a reflective photomask. A transmissive mask can comprise an arbitrary conventional photomask, such as, for instance, a binary mask, a phase shifting mask or a mask for multiple exposure. A reflective photomask can comprise a mask for the extreme ultraviolet (EUV) wavelength range, in particular a binary mask or a phase shifting mask. However, a photomask can also comprise a template for nanoimprint lithography.

The sample stage can be the sample stage of a repair tool. In particular, the repair tool can induce a local etching and/or deposition process. Furthermore, the repair tool can comprise one or more scanning probe microscopes that can be used as manipulators or micromanipulators for processing a defect.

The height change can be measured by at least one height sensor.

The method according to the invention can comprise the additional step of predetermining the non-vanishing distance with respect to the rotation axis. Furthermore, the method according to the invention can comprise the additional step of determining coordinates of the rotation axis on a surface of the photomask.

Determining the coordinates of the rotation axis can comprise: (a) Measuring a first set of coordinates for at least two markings of the photomask by means of a particle beam of at least one particle beam source, without rotating the photomask; (b) Rotating the photomask by an angle $0° < \theta < 180°$ or $180° < \theta < 360°$; and (c) Measuring a second set of coordinates for the at least two markings of the rotated photomask by means of the particle beam of the particle beam source.

A photomask usually has a number of markings that are typically applied at regular intervals on that side of the mask which is structured by the pattern. Each of the markings generally has a reference point. The mask coordinates $(u, v)$, which are typically specified by the mask manufacturer, refer to said point. The coordinates $(u_D, v_D)$ of a defect of the mask are also referred to these reference points. In order to maximize the measurement accuracy when measuring the two reference points of the markings, it is advantageous to use markings which are at the greatest possible distance from one another on the photomask.

On the basis of the two measured coordinate sets of two markings, wherein the photomask is rotated before the second set is measured, the coordinates of the rotation axis of the photomask can be ascertained.

Furthermore, determining the coordinates of the rotation axis can comprise: lowering the sample stage before approaching the at least two markings for the purpose of measuring the first and/or the second set of coordinates, and/or before rotating the sample stage.

This measure prevents the particle beam source and/or the one or more scanning probe microscopes or the micro manipulators thereof from being able to make contact unintentionally with the surface of the photomask during the movement of the photomask.

Determining the coordinates of the rotation axis can comprise: determining the coordinates of the rotation axis from the first and second sets of measured coordinates of the at least two markings.

Choosing a rotation angle in the region of 90° optimizes the accuracy when determining the rotation axis or when determining the coordinates of the rotation axis. It is therefore advantageous to choose an angle in the region of 90° for the rotation of the photomask.

Measuring the at least two markings can be effected by means of the at least one particle beam source configured to generate at least one focused particle beam from the following group: a photon beam, an electron beam, an ion beam, an atomic beam and a molecular beam.

The electron beam of a scanning electron microscope (SEM) or of a modified SEM is often used for measuring the markings, or for the reference points thereof. An electron beam can be focused to a very small spot ($D_S < 1$ nm). This enables a very high lateral resolution when determining the reference points of the markings. Moreover, imaging the markings with an electron beam causes no or only very little damage to the markings and thus to the photomask overall. The markings can be imaged manually and/or in an automated form. By way of example, this can be done by centring a specific structure of the marking, for instance the reference point thereof, in the SEM image. After centring the electron beam in relation to the marking, the measuring transducers of the sample stage indicate the coordinate values sought.

Predetermining the non-vanishing distance with respect to the rotation axis can comprise: determining coordinates of a point of incidence of the particle beam of the at least one height sensor on the photomask. The particle beam of the at least one height sensor can comprise a massless particle beam, for example a photon beam or a light beam, and/or a particle beam having mass, for example an electron beam.

For accurately ascertaining the height change of the photomask during the rotation of the sample stage, it is necessary to know the distance between the coordinates of the rotation axis and the coordinates of the point of incidence of the particle beam of the height sensor on the photomask. Measuring this distance makes it possible to determine the radius of the circle or of the circle segment of the point of incidence of the particle beam of the height sensor on the photomask during the rotation of the sample stage and thus of the photomask during the measurement of the height change.

Determining the coordinates of the point of incidence of the particle beam of the at least one height sensor can comprise: scanning the sample stage for the purpose of centring the at least one height sensor over the at least one of the at least two markings.

Scanning the sample stage can comprise a scan path adapted to one of the at least two markings.

Scanning the sample stage can comprise displacing the sample stage, without rotating the sample stage. Scanning the sample stage can comprise: (a) first scanning of the sample stage in a diagonal direction with respect to a marking to be scanned; (b) displacing the scan path for a second scan by a predefined distance perpendicular to the first scan path; and (c) repeating step (b) until the repeated scan meets a reference point of the scanned marking.

Furthermore, scanning the sample stage can comprise: rotating the sample stage, such that a scanned circle segment covers at least one part of at least one of the at least two markings.

Furthermore, scanning the sample stage can comprise: Carrying out the scanning so that a scan time for centring the at least one height sensor attains a minimum value.

Identifying a reference point of a marking is a complicated process. In contrast to the particle beam of the particle beam source, the particle beam of the height sensor cannot be scanned over the photomask. Rather, a large portion of the sample stage carrying the mask, including the photomask itself, has to be moved in order to determine the position at which the reference point of the marking of the photomask becomes located under the point of incidence of the particle beam of the height sensor. It is therefore very advantageous to choose the scanning of the sample stage so as to minimize the length of the required scan path and thus the time required for scanning.

Measuring the height change can comprise: displacing the rotation axis under a point of incidence of the particle beam of the at least one particle beam source on the photomask.

Measuring the height change can comprise: displacing the coordinates of the rotation axis under a point of incidence of the particle beam on the photomask.

By means of determining the coordinates of the rotation axis on the photomask, it is possible to ascertain the distance between the height sensor and the rotation axis, as explained above, and the radius of the circle or of the circle segment on which the point of incidence of the particle beam of the height sensor runs around the rotation axis during the measurement of the height change is thus known.

The method according to the invention can furthermore comprise the following step: interpolating and/or extrapolating the measured height change of the photomask for a value deviating from the predetermined, non-vanishing distance. Interpolating and/or extrapolating the measured height change can comprise: fitting the measured height change to a mathematical model. Fitting the measured height change to the mathematical model can comprise a fit to function curves.

The method can additionally comprise the following step: interpolating and/or extrapolating the measured height change of the photomask for a distance that does not correspond to the distance between the points of incidence of the at least one particle beam of the particle beam source and the particle beam of the at least one height sensor, for the purpose of determining a height change of an arbitrary position on the photomask.

Interpolating and/or extrapolating can comprise linear interpolating and/or linear extrapolating.

Measuring the height change can furthermore comprise: determining an orientation of the rotation axis in relation to a perpendicular to the mask of the sample stage and/or determining a maximum height change during the rotation of the sample stage.

The perpendicular to the chuck surface of the sample stage corresponds to the z-axis of the coordinate system of the sample stage. A deviation of the orientation of the rotation axis with respect to the perpendicular to the chuck surface or a tilting of the rotation axis relative to the z-axis does not pe se result in a height change measured by the at least one height sensor during the rotation of the photomask as a result of rotation of the sample stage. Rather, a height change of the photomask when a rotation of the sample stage is carried out is caused only if the rotation axis of the sample stage is not aligned perpendicularly to the surface of the photomask, i.e. if the rotation axis has a tilting relative to the normal to the mask.

Moreover, measuring the height change can comprise: setting the at least one height sensor to a central position of its measurement region before the rotation of the sample stage. This ensures that the height sensor can detect the entirety of the height change during the rotation of the sample stage.

The method according to the invention can furthermore comprise the following step: measuring a a z-coordinate of the photomask on the rotation axis. Moreover, the method according to the invention can comprise the following step: measuring a z-coordinate of the photomask at the coordinates of the rotation axis.

The sample stage can be displaceable along at least two axes that are parallel to the chuck surface, and the method according to the invention can furthermore comprise the following steps: (a) Measuring coordinates of at least two markings by means of a particle beam of at least one particle beam source, without rotating the photomask with the sample stage; and (b) Determining an affine transformation between a coordinate system of the photomask and a coordinate system of the sample stage. The coordinate system associated with the sample stage can be the coordinate system related to the chuck surface.

The method for determining an alignment of a photomask can be divided into at least two steps. The sequence of the two steps can be chosen as desired. It is assumed hereinafter that the two steps do not mutually influence one another. In one step, the mask coordinates u, v assigned to the mask design, said mask coordinates typically being made available by the mask manufacturer and thus forming the coordinate system assigned to the photomask, are put into a one-to-one relationship with a coordinate system (x, y) associated with the sample stage. This is preferably the coordinate system related to the chuck surface of the sample stage. A further step involves - as explained above - ascertaining the effect of a rotation axis that is not oriented perpendicularly to the surface of the mask. For this purpose, the photomask is rotated by a predefined angle by the sample stage and the height change that occurs in the process is measured. From the measurement data, it is possible to ascertain a height change of the mask during the rotation thereof and/or the displacement thereof.

After the method according to the invention has been carried out, the coordinates of a defect $u_D$, $v_D$, which are typically specified in mask coordinates, can be converted into the coordinate system of the sample stage $x_D$, $y_D$, $z_D$ as a function of the rotation angle $\theta$. In particular, it is possible to ascertain a height position of the mask or of the defect at the repair position thereof. The sample stage can bring the photomask positioned thereon to an envisaged repair location of the defect. Furthermore, the repair tool can be positioned with great precision for processing the defect.

The method according to the invention can furthermore comprise the following step: determining an affine transformation between a coordinate system of the photomask and a coordinate system of the sample stage from the first set of coordinates of the at least two markings of the photomask.

For reasons of economy in the method, it is expedient for the first measured coordinate set of the two markings, which were measured for determining the coordinates of the rotation axis, to be used again for determining the affine transformation. However, it is also possible to choose two new markings of the photomask and to measure them with the particle beam of the at least one particle beam source.

Determining the affine transformation can comprise: determining the parameters of a translation, a scaling and a rotation of the coordinate systems of the photomask and of the sample stage with respect to one another on the basis of the measured coordinates of the at least two markings.

On the basis of two measured reference points $x_1$, $y_1$ and $x_2$, $y_2$ of two markings and two reference points $u_1$, $v_1$ and $u_2$, $v_2$ that are predefined by the mask manufacturer in the mask coordinate system, it is possible to determine four parameters: two parameters (a, b) of a displacement, one parameter of a rotation (a) and one parameter of a scaling (s).

Determining the affine transformation can comprise: measuring coordinates of at least three markings of the photomask and determining the parameters of a translation, a scaling, a rotation, a shear and a parallel stretching of the coordinate systems of the photomask and of the sample stage. Arbitrary combinations of the affine transformations listed can be described with the aid of a $2 \times 3$ matrix. Determining the six matrix coefficients requires six equations that can be ascertained by the measurements of at least three markings.

Six parameters can be determined with the aid of six equations. Besides the four parameters already determined above, these are the parameters of a shear and a parallel stretching.

The at least one height sensor and/or the at least one particle beam source can be in a known relationship with the coordinate system of the sample stage.

The sample stage can be displaceable along at least two axes that are parallel to a chuck surface of the sample stage, and the method according to the invention can furthermore comprise the following step: measuring a height difference of at least three points on the photomask that do not lie on a straight line by means of the at least one height sensor, without rotating the sample stage.

The method according to the invention can furthermore comprise the following step: interpolating and/or extrapolating the height difference at a position of the photomask that deviates from the three measured points from the measured height difference. Interpolating and/or extrapolating can comprise linear interpolating and/or linear extrapolating.

The interpolating and/or extrapolating step makes it possible to calculate the height of each point of the photomask on account of a skew position or an oblique position of the mask from the measurement data of the three measured points.

The method of determining an alignment of a photomask can thus be divided into three parts. The order in which the individual parts of the method are carried out can be chosen as desired. It is expedient, however, for the part mentioned last to be carried out first. On the basis of the measured height difference, it is possible - as already described above - to ascertain an oblique or skewed position of the photomask on the sample stage. This position can be taken into account when carrying out the measurements for the further parts of the method. It is thus possible reliably to prevent damage to the mask when carrying out translational movements of the mask that are carried out in order to bring said mask to the positions required for the measurements.

After the method according to the invention has been carried out, the coordinates of a defect $(u_D, v_D)$, which are typically specified in mask coordinates, can be converted into the coordinate system of the sample stage $(x_D, y_D, z_D)$. In particular, it is possible to ascertain a height position of the mask or of the defect at the repair position thereof. The sample stage can bring the photomask positioned thereon to an envisaged repair location of the defect. Furthermore, the repair tool can be positioned with great precision for processing the defect.

The z-coordinate or the height of a point on the front side of the mask, i.e. the side that carries a pattern, is composed of three contributions: (a) the height of the photomask at the position of the rotation axis, (b) a height change of the point under consideration in relation to the rotation axis on account of an oblique position of the mask, and (c) a height change of the point under consideration in relation to a rotation on account of a rotation axis not directed perpendicularly to the surface of the mask. The actual z-coordinate of the point under consideration results from addition of these three contributions. The three contributions are additive and are dependent on the rotation angle $\theta$.

In a first embodiment, a device for determining an alignment of a photomask on a sample stage which is displaceable along at least one axis that is parallel to a chuck surface of the sample stage, and is rotatable about at least one axis that is perpendicular to the chuck surface, comprises: at least one height sensor configured for measuring a height change during rotation of the sample stage by a predefined angle, wherein the at least one height sensor is at a predetermined, non-vanishing distance with respect to the rotation axis, for the purpose of determining the alignment of the photomask on the sample stage.

The height sensor can comprise a chromatic confocal sensor. The height sensor can furthermore comprise at least one element from the group: an optical microscope, a capacitive distance sensor, an interferometer and a scanning probe microscope. A scanning probe microscope can comprise an atomic force microscope (AFM), a scanning tunnelling microscope (STM), a magnetic force microscope, a scanning near-field optical microscope and a scanning near-field acoustic microscope. Furthermore, the height sensor can comprise a scanning electron microscope (SEM).

The device can be configured to carry out the steps of the method according to the invention. The device can be configured to carry out the method according to the invention in an automated form. In particular, the device can be configured to automatically carry out different aspects of the method according to the invention by themselves or in combination with other aspects.

Finally, a computer program can comprise instructions which, when they are executed by a computer system, cause the computer system to carry out the method steps of the method described above.

## 4. Description of the drawings

The detailed description that follows describes currently preferred exemplary embodiments of the invention with reference to the drawings, wherein:

Fig. 1      illustrates a schematic view of an exemplary sample stage having three translation axes and one rotation axis;

Fig. 2      presents a schematic section through the exemplary sample stage from Fig. 1;

Fig. 3      represents the various coordinates of the coordinate systems within an exemplary sample stage and the coordinate system associated with a photomask;

Fig. 4      elucidates a skew position of the photomask on the sample stage from Fig. 1, and schematically illustrates a particle beam source for scanning markings of the photomask and a height sensor for measuring a z-coordinate of the photomask;

Fig. 5      schematically illustrates the measurement of the z-coordinate by means of the height sensor for various mask patterns;

Fig. 6      illustrates a plan view of one type of a marking with the associated reference point thereof;

Fig. 7      shows a plan view of an exemplary photomask having three markings;

Fig. 8      illustrates a first example of the scanning of a height sensor within the marking from Fig. 6;

Fig. 9a     illustrates the first part of the flow diagram of the scanning of the height sensor in accordance with the first example from Fig. 8;

Fig. 9b     reproduces the second part of the flow diagram of the scanning of the height sensor in accordance with the first example from Fig. 8;

Fig. 10     elucidates a second example of the scanning of a height sensor within the marking from Fig. 6;

Fig. 11     shows a plan view of the photomask from Fig. 7 in a state rotated by 90°;

Fig. 12     presents a plan view of the photomask from Fig. 7 after a rotation with an arbitrary rotation angle;

Fig. 13     schematically elucidates a translation induced by a rotation;

Fig. 14     illustrates a skew position of a photomask on the sample stage and represents a rotation axis that is not oriented perpendicularly to the mask, and therefore results in a wobble movement of the photomask during the rotation thereof;

Fig. 15     shows in the upper partial image a plan view of the mask from Fig. 7, in which at a distance $d_0$ from the rotation axis the height change and the height profile during the rotation of the mask are measured, and illustrates in the lower partial image a deviation of the orientation of the rotation axis from the perpendicular to the photomask;

Fig. 16     shows one example of a height profile as a function of the rotation angle for a rotation axis that is not aligned perpendicularly to the mask;

Fig. 17     represents a flow diagram of the method according to the invention for determining an alignment of a photomask on a sample stage;

Fig. 18a    shows the first part of the flow diagram from Fig. 17 with details being specified to a greater degree; and

Fig. 18b    illustrates the second part of the flow diagram from Fig. 17 with details being specified to a greater degree.

**5. Detailed description of preferred exemplary embodiments**

Currently preferred embodiments of the method according to the invention and of the device according to the invention are explained below. The method according to the invention will be explained in detail on the basis of determining an alignment of a photomask on a sample stage which, besides three translation axes, additionally has one rotation axis. For applying the method described here, it is not necessary for a sample stage to have three translation axes; one displacement axis parallel to a sample receiving surface and one rotation axis aligned perpendicularly to the sample receiving surface are sufficient for this. Furthermore, the method according to the invention and the device according to the invention are not limited to the alignment of a photomask on a sample stage. Rather, they can be used not only for aligning templates for nanoimprint lithography but also for aligning arbitrary components in microsystems technology if said components have markings.

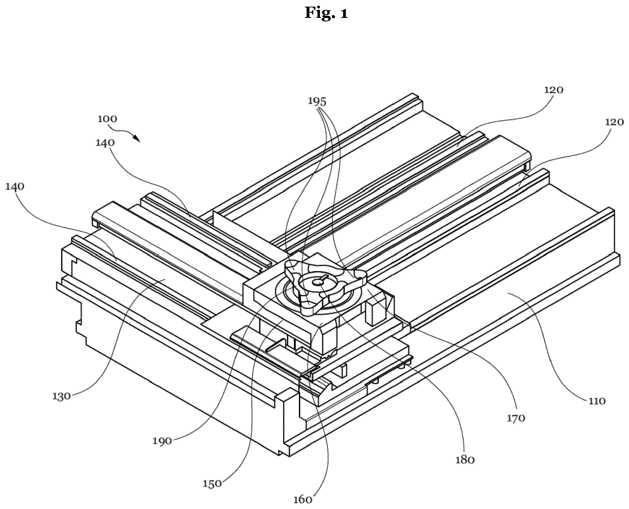

Fig. 1 shows a schematic view of an exemplary sample stage 100 having three translation axes and one rotation axis. The translation axes are substantially mutually perpendicular to one another and thus form an orthogonal coordinate system. The sample stage 100 hereinafter is also called mask stage 100 or stage 100. The baseplate no of the sample stage 100 has rails 120 for displacing the chuck surface of the sample stage 100 in the y-direction. The slide 130 of the sample stage 100 can be moved on the rails 120 along the y-axis. On its top side, the slide 130 carries rails 140 enabling a second slide 150 of the sample stage 100 to be displaced along the x-direction. The second slide 150 forms the baseplate 160 for the displacing unit 170 in the z-direction. The rotation axis 180 is arranged on the displacing unit 170 of the sample stage 100 for the z-direction, said rotation axis being oriented or aligned parallel to the z-direction. The rotation axis 180 carries the chuck 190, the mask holder 190 or the mask plate 190. Hereinafter the chuck surface 195 of the chuck 190 denotes the sum of the points on which a photomask, on its underside, which has no pattern, bears on the chuck 190.

Here - and also elsewhere in the description - the expression "substantially" denotes a measurement variable within the margin of error thereof if measuring devices in accordance with the prior art are used for measuring the variable.

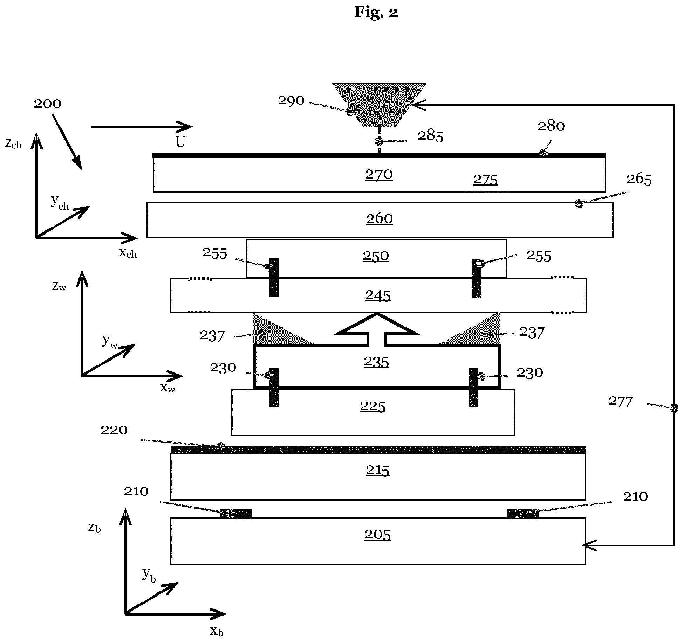

The diagram 200 in Fig. 2 presents a schematic section through the sample stage 100 from Fig. 1. The coordinate systems of the sample stage 100 are additionally indicated on the left-hand side. The coordinate system $x_b$, $y_b$, $z_b$ relates to the baseplate 205 of the sample stage 100 from Fig. 1.

The baseplate 205 carries the rails 210 for displacing the slide 215 in the y-direction, oriented perpendicularly to the plane of the drawing. The slide 215 has on its top side the rails 220 for moving the second slide 225 in the x-direction. The second slide 225 forms the baseplate for the displacing unit 235 in the z-direction. The displacing unit 235 is fixed on the second slide 225 with the aid of the securing pins 230. By displacing the wedges 237, the upper plate 245 can be moved in the z-direction.

On the upper plate 245 bearing on the displacing unit 235, the rotation axis 250 is in turn fixed with the aid of the pins 255. The coordinate system associated with the top side of the upper plate 245 is abbreviated hereinafter with $x_w$, $y_w$, $z_w$. The rotation axis 250 of the sample stage 100 from Fig. 1 is oriented in the z-direction. As already explained above, the rotation axis 250 carries the chuck 260 or the chuck surface 265. The chuck 260 can comprise a three-point mounting. However, it is also possible for the chuck 260 to fix a photomask 270 on the chuck 260 with the aid of electrostatic forces (electrostatic chuck) or by generating a vacuum (vacuum chuck). The coordinates associated with the top side of the chuck 260 are designated hereinafter as $x_{ch}$, $y_{ch}$, $z_{ch}$.

The chuck 260 or the mask plate 260 carries the photomask 270. The mask 270 can be a transmissive mask or a reflective mask. A photomask 270 typically comprises at least a substrate 275 and a pattern 280. The substrate 275 can comprise a quartz substrate and/or a material with a low coefficient of thermal expansion (LTE (low thermal expansion) substrate). The pattern 280 can be the pattern of a binary photomask 270. In this case, the pattern 280 can comprise an absorber structure and can comprise chromium, for example. However, the pattern 280 can also comprise the pattern 280 of a phase shifting photomask 270. A phase shifting mask 270 can be produced for example by etching a corresponding pattern 280 into the substrate 275 of the mask 270. Furthermore, it is possible for the pattern 280 to comprise structure elements which both shift the phase of the actinic radiation relative to the radiation incident on the substrate 275 and absorb part of the light at the actinic wavelength that is incident on the pattern 280. Examples thereof are OMOG (opaque MoSi (Molybdenum Silicide) On Glass) masks.

Reflective masks 270 comprise photomasks for the extreme ultraviolet (EUV) wavelength range, having an actinic wavelength that is typically in the range of 10 nm to 15 nm. EUV masks can be embodied as binary masks and/or as phase shifting masks.

The arrow u directed towards the right describes the u-coordinate of the mask coordinate system in Fig. 2. The coordinates $x_{ch}$ and $y_{ch}$ can be measured by means of the particle beam 285 of the particle beam source 290 and can be put into a relationship with the coordinate system $x_b$, $y_b$, $z_b$ of the baseplate 110, 205. The particle beam source 290 is in a known relationship with the baseplate 110, 205 of the sample stage 100. This relationship is symbolized by the double-headed arrow 277 in Fig. 2.

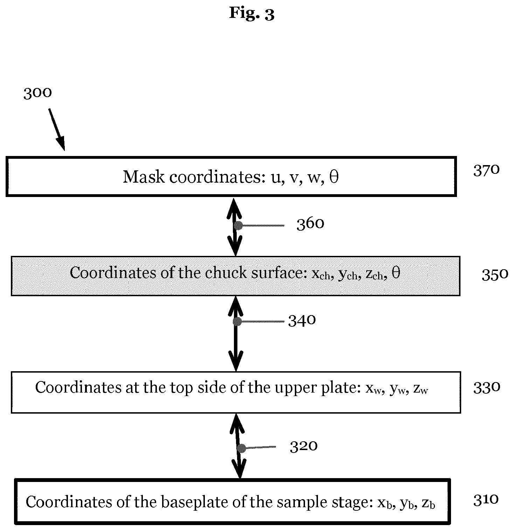

The diagram 300 in Fig. 3 represents schematically again the various intermediate stages of the coordinate systems within the sample stage 100 as far as the coordinate system of the photomask 270. As indicated in block 310, the coordinate system related to the baseplate 205 of the sample stage 100 is designated by $x_b$, $y_b$, $z_b$, wherein the letter b stands for "base". The double-headed arrow 320 in Fig. 3 symbolizes the transition from the baseplate 205 of the sample stage 100 to the top side of the upper plate 245, to which the rotation axis 250 is fitted. As indicated in block 330, the associated coordinate system is abbreviated to $x_w$, $y_w$, $z_w$, wherein the index w stands for "wedge". Relative to the coordinate system of the baseplate 110, 205, the coordinate system $x_w$, $y_w$, $z_w$ can have translations in all three spatial directions.

The double-headed arrow 340 elucidates the transition from the coordinate system associated with the upper plate 245 to the coordinate system of the chuck 260. This coordinate system has - relative to the coordinate system of the baseplate - besides three translation coordinates a rotation angle $\theta$ describing the rotation of the sample stage 100 and thus of the photomask 270 about the rotation axis 250 of the sample stage 100: $x_{ch}$, $y_{ch}$, $z_{ch}$, $\theta$. The index "ch" stands for the chuck 260: "chuck". This coordinate system is indicated in the block 350 in Fig. 3. The coordinate system associated with the chuck 260 can have a rotation $\theta$ about the rotation axis 250 relative to the coordinate system coupled to the upper plate 245.

Finally, the double-headed arrow 360 symbolizes the transition from the coordinate system of the sample receptacle or the chuck 190, 260 to the coordinate system associated with the photomask 270: u, v, w, $\theta$. As explained above, the associations of the various coordinate systems within the sample stage 100 are known. This means that the position of the particle beam 285 of the particle beam source 290 is in a known relationship with the coordinate system of the baseplate 110, 205 of the sample stage 100.

The reference point of the focused electron beam 285 of the SEM 290 can be chosen such that the following holds true: u=0, v=0, w=0, $\theta$=0. After a corresponding adjustment the electron beam 285 of the SEM 290 is typically circular and thus rotationally invariant. If a rotation about the rotation axis 250 does not occur, the coordinate systems of the mask 270 and of the mask holder 260 are reduced to u, v, w and $x_{ch}$, $y_{ch}$, $z_{ch}$. For describing the structure elements of a pattern, as well as defects possibly present, only the lateral coordinates u, v of the mask coordinate system u, v, w are of importance. Therefore, a mask manufacturer specifies for the reference points of markings typically only the u- and v-coordinates thereof.

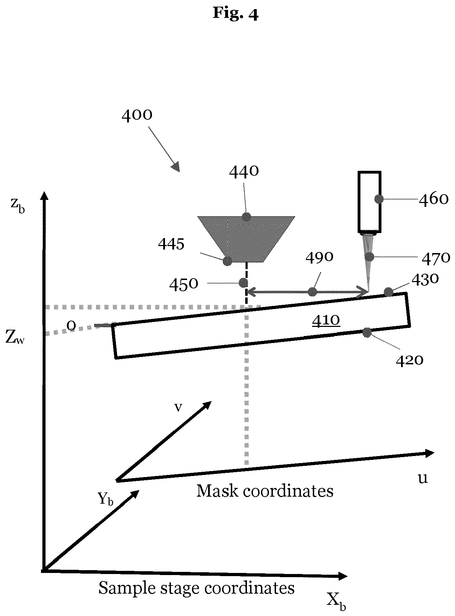

The diagram 400 in Fig. 4 elucidates the determination of an oblique position or a skew position of the photomask 410 on the chuck 190, 260. An oblique position of the mask 410 can be caused by a skewing of the chuck 190, 260. It is also possible for the chuck 190, 260 and/or an underside 420 of the photomask 310 to have one or more particles that result in a skew position of the mask 410 (not illustrated in Fig. 4). It goes without saying that a combination of skewing of the chuck 190, 260 and one or more particles between the chuck surface 195, 265 and the underside of the photomask 410 can also result in an oblique position of the mask 410.

Fig. 4 represents a device 400 comprising a modified scanning electron microscope (SEM, Scanning Electron Microscope) 440 as an example of a particle beam source 440. Hereinafter, the particle beam source 440 is always realized as a modified SEM. From the output of the column 445 of the SEM 440, an electron beam 450 can be scanned over the top side 430 or front side 430 of the photomask 410. As already explained above, an electron beam 450 can be focused to a very small spot, such that the latter has a very small lateral extent during the scanning of the mask 410. For this reason, a focused electron beam 450, in the presence of a suitable precursor gas, can induce (not illustrated in Fig. 4), a laterally delimited chemical etching reaction (EBIE, Electron Beam Induced Etching) or a locally delimited chemical deposition reaction (EBID, Electron Beam Induced Deposition).

It is also possible, as an alternative or in addition to the electron beam 450, to use an ion beam, for instance a beam of gallium ions, for scanning the photomask 270, 410 or for scanning a marking of the mask 270, 410. Atomic and/or molecular beams, for example a helium beam, can likewise be used for this purpose. Finally, photon beams can also be used for scanning photomasks 270, 410 or the markings thereof. When photons are used, it is expedient to use any particle beam source having the shortest possible wavelength, for example a particle beam source for the EUV wavelength range. As the wavelength of the photon beam used decreases, the resolution capability of the photo beam source increases. In an alternative exemplary embodiment, a digital camera can be used for imaging a marking of the mask 270, 410.

The resolution capability of a focused electron beam 450 in the beam direction is limited, however, on account of the profile of said beam in the beam direction. For this reason, the device 400 comprises a height sensor 460, which can be used for detecting a height or the z-coordinate of the photomask 410, 460. The height sensor 460 directs a particle beam in the form of a light beam 470 onto the top or front side 430 of the photomask 410 and determines the distance between the height sensor 460 and the top side 430 of the photomask 410 on the basis of the radiation reflected from the front side 430, said radiation not being represented in Fig. 4. The height sensor 460 can thus be used to bring the photomask 410, 460 to the working distance of the electron beam 450.

The height sensor 460 can be embodied in the form of an interferometer, for example as a Fabry-Perot interferometer or as a white light interferometer. However, the height sensor 460 can also be realized as a confocal point sensor, as a chromatic confocal sensor or as a confocal laser scanning microscope. The height sensor 460 typically has a resolution capability in the submicron range. In order to extend the resolution range of the height sensor 460, the height sensor 460 can comprise two or more sensors having different measurement ranges and resolution capabilities. It thus becomes possible to measure the distance between the top side 430 of the mask 410 and the height sensor(s) 460 with coarse resolution in a first step and then with increasingly higher resolution in one or more subsequent steps.

The height sensor 460 ascertains the distance between the height sensor 460 and the top side 430 of the photomask 410 for at least three points of the surface of the mask that do not lie on a straight line. For this purpose, the sample stage 100 displaces the photomask 410 along the x-direction and the y-direction. In order to minimize the measurement error when determining the height difference from the three measured points, it is advantageous to choose the measurement points such that they are at the greatest possible distance from one another. A large distance between the at least three measurement points of the height sensor 460 can be D > 5 cm, for example. Furthermore, in order to minimize the measurement error when measuring the height difference it is expedient if the three measurement points span a rectangular coordinate system.

Furthermore, the device 400 comprises the exemplary sample stage 100, which is not represented in Fig. 4. Furthermore, the coordinate system $x_b$, $y_b$, $z_b$ assigned to the baseplate 110, 205 of the sample stage 100 and the coordinate system u, v associated with the photomask 410 are indicated in Fig. 4. Finally, the coordinate $z_w$ represents the height change of the photomask 410 on account of the oblique or skewed position thereof.

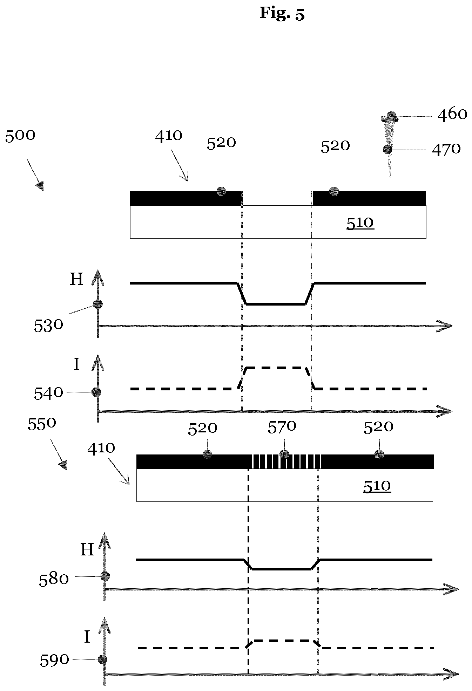

The upper partial image 500 in Fig. 5 elucidates the measurement data for ascertaining an oblique position of a mask from the height difference of at least three measurement points, wherein the mask 410 has only a sparse pattern 520. The data measured by the height sensor 460 represents a superimposition of an oblique position of the mask 410 and the pattern geometry. This relationship is illustrated in the diagram 530 arranged under the mask 410. The diagram 540 presents the variation of the optical intensity detected by the height sensor 460 if the height sensor 460 is scanned over a pattern element 520, the substrate 510 and then over a second pattern element 520. The height or the thickness of a pattern element 520 is in the range of 70 nm to 100 nm for a binary mask, for example. This means that, in the example indicated in Fig. 5, the resolution of the height sensor 460 is approximately 10 nm.

The lower partial image 550 in Fig. 5 illustrates the scanning of the height sensor 460 over a mask 410 having a dense pattern 570. The diagrams 580 and 590 represent the measured height profile and the intensity profile detected by the height sensor 460 during the scanning of the height sensor 460 over the dense pattern 570. The height measured over the dense pattern 570 is a combination of the height of the substrate 510 and the height or the distance of the top side of the pattern 570 from the height sensor 460.

In order to avoid a deterioration in the resolution when measuring the height difference of at least three points distributed over the mask 410, measurement points which lie within a dense pattern 570 should be disregarded, whenever possible, when determining a height difference of the at least three measurement points. In this case, the measured intensity profile 540, 590 of the height sensor 460 can be used to establish whether or not a measurement point lies in a dense pattern 570. If it is established that a measurement point of the height sensor 460 lies in the region of a dense pattern 570, this measurement point should be discarded and replaced by a measurement point that becomes located either on a large-area pattern element 520 or on the substrate 510 of the photomask 410.

From the height difference of at least three measurement points that is measured by the height sensor, it is possible to determine the plane which is spanned by the at least three measurement points and in which the top side 430 of the photomask 410 is embedded. An oblique position of the mask 410 can be determined as a result. A variation of the height of the top side 430 of the photomask for an arbitrary point of the mask can be determined by ascertaining this point on the surface of the mask. It is also possible, of course, to determine the height or the z-coordinate of an arbitrary point on the surface of the mask by interpolating and/or extrapolating the height difference of the at least three points measured by the height sensor.

As soon as the oblique position of the photomask 410 is known, this can be taken into account when translational movements are carried out by the sample stage 100. As a result, it is possible reliably to prevent translational movements of the sample stage 100 from resulting in unintended damage to a skew mounted photomask 410 and/or the SEM 440. Besides an SEM 440, a device for identifying and for repairing a photomask 410 can comprise one or more scanning probe microscopes, not illustrated in Fig. 4. Said scanning probe microscopes are often fitted at a certain distance from the SEM 440 in the vicinity of the top side 430 of the photomask 410. In the case of a skew mounted mask, it can easily happen that carrying out translational movements for large distances results in a probe and/or a micromanipulator of a scanning probe microscope unintentionally making contact with the photomask 410. After ascertaining the oblique position of the photomask 410, this problem can be avoided.

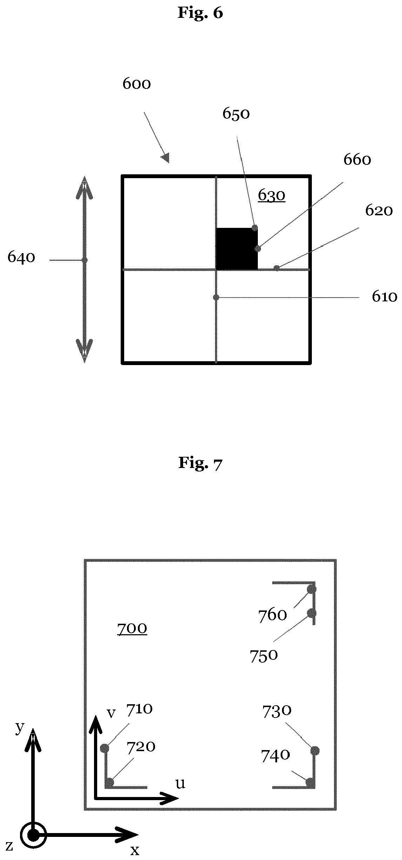

Fig. 6 presents an example of a marking 600 or of a reference sign 600. Markings 600 are applied by the mask manufacturer typically at regular or irregular intervals on a photomask 270, 410. The exemplary marking 600 has a square shape having an edge length 640 of 350 $\mu$m. The marking 600 is divided into four quadrants by two crosspieces 610 and 620. In the top right quadrant 630, the marking 600 has a small square 660. The top right corner of the square 660 defines the reference point 650 of the marking 600.

The white or transparent part 630 of the marking 600 can be the substrate 275, 510 of the photomask 270, 410. The crosspieces 610, 620 and the small black square 660 can comprise absorber material, for example of a binary photomask 270, such as chromium for instance.

The marking 600 can be scanned by means of the electron beam 450 of the SEM 440 and the reference point 650 of the reference sign 600 can be ascertained from the scan data.

Fig. 7 shows a schematic plan view of a photomask 700. The exemplary photomask 700 has three markings 710, 730, 750 in the form of right angles at three corners. The reference points 720, 740 and 760 of the exemplary markings 710, 730 and 750 form the points of intersection of the interior of the right angles. The coordinate system u, v associated with the photomask 700 is indicated on the mask 700. The reference points $u_1$, $v_1$, $u_2$, $v_2$ and $u_3$, $v_3$ in the mask coordinate system u, v are provided to the user of the mask 700 by the mask manufacturer. The markings 710, 730 and 750 often have the form of the marking 600 from Fig. 6.

By means of the electron beam 450 of the SEM 440, at least two of the three markings 710, 730, 750 are scanned in order to determine at least two reference points 720, 740, 760 of the three markings 710, 730, 750. In order to position the markings 710, 730, 750 under the electron beam 450 of the SEM 440, the sample stage 100 carries out exclusively translational movements of the chuck 190, 260 in the x-direction and y-direction. A rotational movement of the sample stage 100 for determining the reference points 720, 740, 760 is not carried out. As soon as one of the markings 710, 730, 750 is positioned under the electron beam 450, the electron beam 450 scans the marking 710, 730, 750 in order to ascertain the reference point 720, 740, 760 thereof.

After the scanning of two markings, for example the markings 710, 730, the reference points 720, 740 thereof in the coordinate system x, y of the sample stage 110 are known: $x_1$, $y_1$ and $y_1$, $y_2$. With the aid of the two measured reference points $x_1$, $y_1$ and $x_2$, $y_2$ and also the reference points $u_1$, $v_1$ and $u_2$, $v_2$ provided by the mask manufacturer, it is possible to determine a displacement, a rotation and a scaling of the two coordinate systems with respect to one another. An affine transformation combines the measured reference points $x_1$, $y_1$ and $x_2$, $y_2$ with the reference points $u_1$, $v_1$ and $u_2$, $v_2$ provided by the mask manufacturer. If only two markings are used, then a general affine transformation is underdetermined. Such an embodiment restricts an affine transformation to a displacement (offset), a scaling and a rotation.

The established description of affine coordinates is given in a matrix representation using homogeneous co-ordinates:

$$\begin{bmatrix} u \\ v \\ 1 \end{bmatrix} = \begin{bmatrix} a_0 & a_1 & a_2 \\ b_0 & b_1 & b_2 \\ 0 & 0 & 1 \end{bmatrix} \begin{bmatrix} x \\ y \\ 1 \end{bmatrix}$$

In the case of the alignment of the two coordinate systems with respect to one another on the basis of two reference points, for example the reference points 720 and 740, the general vector equation above is reduced:

$$\begin{bmatrix} u \\ v \\ 1 \end{bmatrix} = \begin{bmatrix} s \cdot \cos \alpha & -s \cdot \sin \alpha & a \\ s \cdot \sin \alpha & s \cdot \cos \alpha & b \\ 0 & 0 & 1 \end{bmatrix} \begin{bmatrix} x \\ y \\ 1 \end{bmatrix}$$

In this case, the parameters denote: a, b a displacement or an offset, s a scaling; and $\alpha$ a rotation angle of the two coordinate systems with respect to one another.

Inserting the measured and the predefined reference points 720, 740 results in a system of equations that can be solved using methods of linear algebra. If, for the photomask 700, the reference points 720, 740, 760 of the three markings 710, 730, 750 are measured and inserted into the general vector equation, the parameters of a shear m and a rotation stretching can additionally be determined besides a displacement a, b, a scaling s, a rotation a.

The coordinates of an identified defect $u_D$, $v_D$ are typically indicated in coordinates of the coordinate system u, v linked with the photomask 270, 410, 700. After the parameters of the affine transformation have been ascertained, these coordinates can be converted into coordinates of the sample stage 100. As already explained above, the SEM 440 operates with coordinates of the sample stage 100.

A description will now be given below of how to determine a height change of a photomask 270, 410, 700 as a consequence of a wobble movement of the mask 270, 410, 700 caused by a rotation axis not oriented perpendicularly to the mask 410 or to the top side 430 of the mask 410. The step described first of determining a distance 490 between the SEM 440 and the height sensor 460 or the points of incidence of the particle beam 450 of the SEM 440 and the particle beam 470 of the height sensor 460 on the photomask 270, 410, 700 is necessary only if this distance is not already known. This is the case, for example, after service work that has altered this distance has been carried out on the device 400.

The distance 490 is ascertained in two substeps. In the first substep, the height sensor 460 is positioned under a reference point 720, 740, 760 of the markings 710, 730, 750 that had already been measured by means of the electron beam 440 of the SEM 450. If only the two markings 710 and 730 had been measured by means of the electron beam 440 of the SEM 450, one of the markings 710 or 730 is selected for this purpose.

This process may be very time-consuming if the sample stage 100 scans the marking in a manner similar to the electron beam 450 of the SEM 440. In contrast to the electron beam 450 of the SEM 440, the particle beam 470 of the height sensor is stationary. Therefore - in contrast to the case during the scanning of the electron beam 450 - in order to position the particle beam 470 of the height sensor 460 under a reference point 720, 740, 760 of one of the markings 710, 730, 750, the photomask 270, 410, 700 has to be moved under the particle beam 470 of the height sensor 460. This necessitates moving the mass of the photomask 270, 410, 700 and a large portion of the mass of the sample stage 100. For this reason, centring the particle beam 470 of the height sensor 460 under one of the reference points is a time-consuming process. Simply scanning the photomask 270, 410, 700 by carrying out translational movements of the sample stage 100 is therefore not effective in practice. Rather, it is very advantageous to choose the scan path of the sample stage such that the reference point 720, 740, 760 of one of the markings 710, 730, 750 becomes located under the particle beam 470 of the height sensor 460 after the shortest possible scan time, i.e. after the fewest possible translational movements of the sample stage 100. The scan path for which this is applicable depends on the type of marking 500, 710 present on the photomask 270, 410, 700.

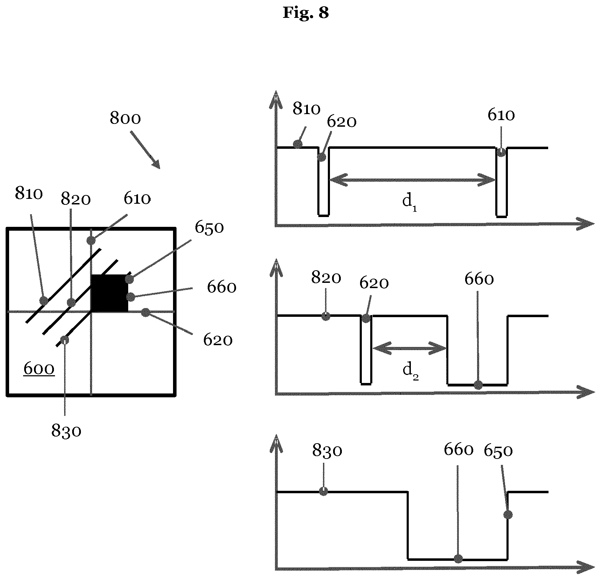

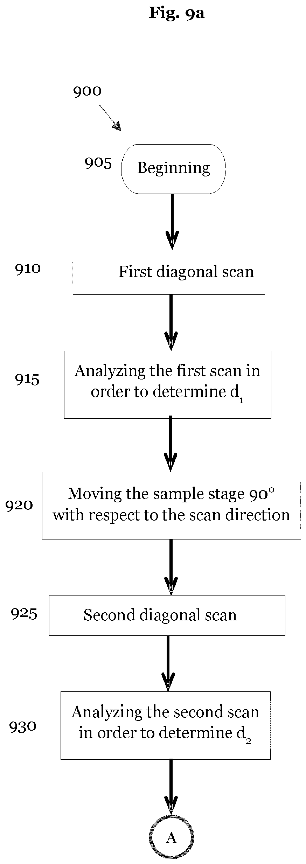

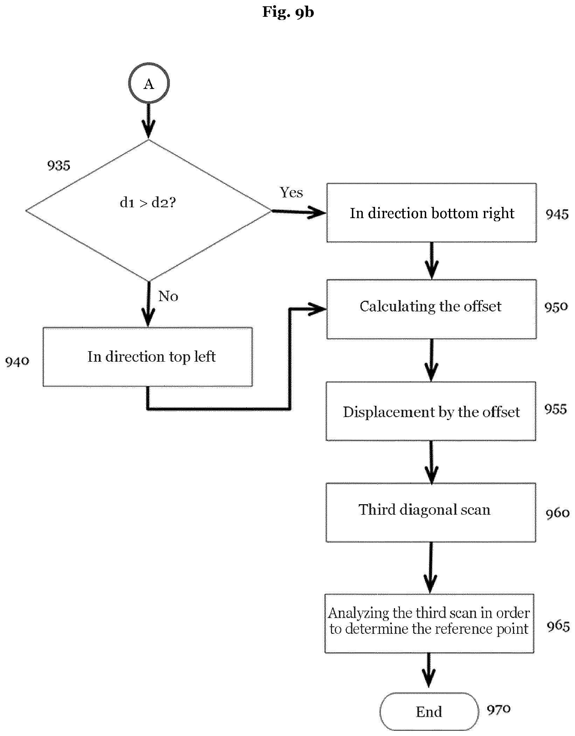

Fig. 8 schematically presents for the exemplary marking 600 from Fig. 6 an expedient scan path that makes it possible to position or to centre the reference point 650 of the marking 600 under the particle beam 470 of the height sensor 460 after a short scan time. The flow diagram 900 in Figures 9a and 9b indicates the various steps for centring the particle beam 470 of the height sensor 460 under the reference point 650. The method begins at 900. Step 905 involves scanning the sample stage 100 within the marking 600 in a diagonal direction in relation to the crosspieces 610 and 620. This first scan is symbolized by the straight line 810 in the partial image on the left in Fig. 8. The length of the first scan 810 is chosen such that the particle beam 470 of the height sensor 460 "sees" or images the crosspieces 610 and 620 of the marking 600. The intensity signal detected by the height sensor 460 during the first scan 810 is illustrated in the top right partial image in Fig. 8. At the positions of the crosspieces 610 and 620, the absorber material thereof has the effect that the intensity signal reflected from the marking dips, or vanishes.

After the first scan 810, in step 915 the signal detected by the height sensor 460 is analyzed and the distance $d_1$ between the two crosspieces 610 and 620 is determined. Then, in step 920, the sample stage 100 is displaced perpendicularly to the diagonal scan direction by a predefined distance. The next step 925 involves carrying out a second scan 820, as indicated in Fig. 8. Afterwards, in step 930, the distance $d_2$ between the two crosspieces 610 and 620 of the marking 600 is ascertained for the second scan 820. This is elucidated schematically in the middle left partial image in Fig. 8. The wider range of vanishing signal indicates that the second scan 820 leads partly through the square 660 of the marking 600.

Decision block 935 then involves deciding whether the distance $d_1$ is greater than $d_2$. If this is applicable, the displacement of the sample stage 100 between the first scan 810 and the second scan 820 has been effected in the correct direction, i.e. in the direction of the reference point 650 of the marking 600. As indicated in block 945, this is the direction towards the bottom left. Step 950 then involves ascertaining the offset or the displacement of the sample stage 100 that is necessary in order to lead the third scan 830 diagonally through the square 660 and thus the reference point 650 of the marking 600. In step 955, the sample stage 100 is displaced perpendicularly to the second scan 820 by the offset ascertained.

In step 960, the third scan 830 is carried out with the aid of the sample stage 100. The third scan 830 is effected, as illustrated in Fig. 8, along the diagonal of the square 660. Afterward, in step 965, the third scan 830 is analyzed and the reference point 650 of the marking 600 is determined from the third scan 830. This is indicated schematically in the bottom left partial image in Fig. 8. The sought reference point 650 of the marking 600 is the point in the top right corner of the square 660 of the marking 600 at the right-hand edge of the region of the third scan 830 with vanishing detected signal. Finally, the method ends in step 970.

If, in decision block 935, it is established that the distance $d_2$ is greater than $d_1$, the direction of the displacement of the sample stage 100 for the next scan is reversed with respect to the displacement carried out between the first scan 810 and the second scan 820. This is implemented in block 940 in Fig. 9. Step 950 involves ascertaining the offset that is necessary in order to lead the third scan 830 through the diagonal of the square 660 and thus the reference point 650 of the marking 600. The further steps are then carried out as already explained in the preceding section.

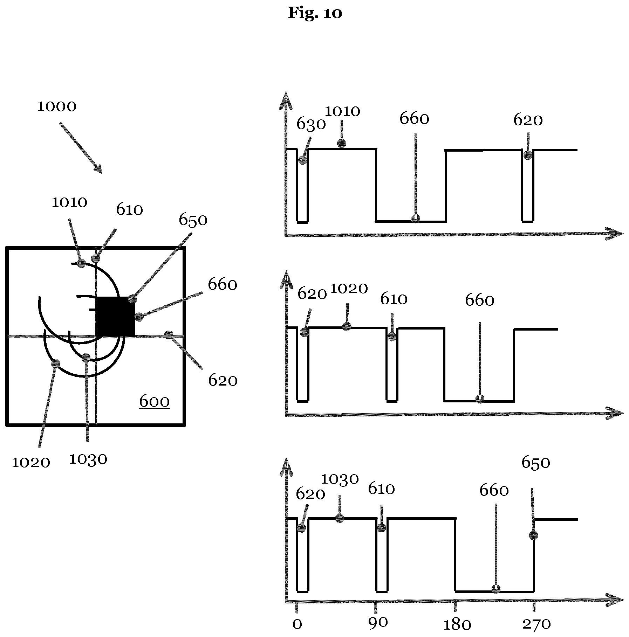

Fig. 10 schematically shows an alternative method for centring a reference point 720, 740, 760 of a marking 710, 730, 750 of a photomask 270, 410, 700 under the particle beam 470 of the height sensor 460. Instead of the translational movements of the sample stage 100 explained above, it is also possible, with the aid of a rotation of the sample stage 100 about a defined rotation axis or a pivot point within one of the markings 710, 730, 750, to position the particle beam 470 of the height sensor 460 under the reference point 720, 740, 760 thereof.

Fig. 10 represents a first scan 1010 within the marking 600. The top right partial image in Fig. 10 illustrates the intensity profile detected by the height sensor 460 during the rotation of the sample stage 100. The two dips in the detected optical intensity of the first scan 1010 represent the scanning of the particle beam 470 of the height sensor 460 under the crosspieces 610 and 620. The wider range of vanishing reflected optical intensity represents the scanning of the particle beam 470 of the height sensor 460 over a part of the square 660 of the marking 600.

After displacing the pivot point of the rotation axis within the marking 600, a second scan 1020 is carried out by rotating the rotation axis 250 of the sample stage 100. The result of that is illustrated in the middle left partial image in Fig. 10. This shows once again the scanning of the particle beam 470 of the height sensor 460 over the two crosspieces 610 and 620 and the square 660 of the marking 600. From the two scans 1010 and 1020, the displacement - effected between the two scans - of the rotation axis within the marking 600 and also the change in the radius of the circular rotational movement, the pivot point and the radius of the circular scan which leads the third scan 1030 through the reference point 650 of the marking 600 are ascertained. The bottom left partial image represents the intensity profile detected by the height sensor 460 during the circular scan. The sought reference point 650 of the marking 600 can be determined from the scans 1010, 1020 and 1030 as the top right corner 650 of the square 660 of the marking 600. Determining the reference point 650 of the marking 600 by means of the circular or crescent-shaped scans 1010, 1020 and 1030 is more complicated compared with the linear scans 810, 820, 830 explained with reference to Fig. 8.

After the centring of the particle beam 470 of the height sensor 460, the coordinates thereof in the coordinate system of the sample stage 100 are known. As explained above, the marking 710, 730 or 750 selected for the centring of the particle beam 470 of the height sensor 460 had already been scanned by means of the electron beam 450 of the SEM 440. The sought distance 490 between the particle beam 450 of the SEM 440 and the particle beam 470 of the height sensor 460 is given by the difference between the coordinates of the reference point 650 of the marking 710, 730 or 750 that are measured by the SEM 440 and the coordinates of the reference point 710, 730, 750 of the marking 710, 730 or 750 that are measured by the height sensor 460.

The three steps described below serve for determining the position of the rotation axis on the photomask 270, 410, 700. These calibration steps have to be carried out once for a new or a modified device 400. Furthermore, these calibration steps need to be carried out if the coordinates of the electron beam 450 of the SEM 440 in relation to the coordinate system of the sample stage 100 have been lost.

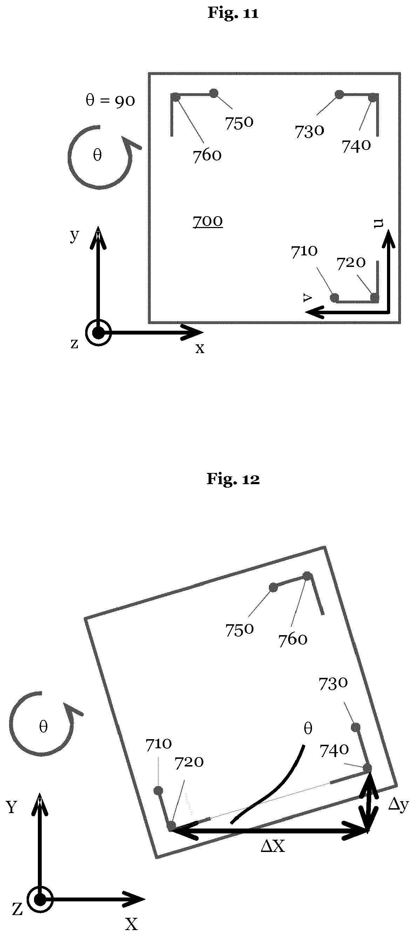

In the first substep for ascertaining the position of the rotation axis, the photomask 270, 410, 700 with the sample stage 100 is rotated by 90°. Fig. 11 presents the photomask 700 from Fig. 7 rotated about the z-axis of the coordinate system of the sample stage 100 by 90° in the anticlockwise direction. A rotation of the photomask 270, 410, 700 by a rotation angle of 90° is advantageous since the choice of this angle makes it possible to determine the position of the rotation axis in relation to the photomask 270, 410, 700 with minimal error. However, it is also possible to choose a rotation angle within the range $0 < \theta < 180°$.

Since, at the time of the rotation of the photomask 700, a possible wobble movement owing to the rotation is not yet known, it is advantageous, before carrying out the rotation, to increase the distance between the output of the column 445 of the SEM 440 and, if present, between the probe(s) or micromanipulator(s) of one or more scanning probe microscope(s), in order to prevent damage to the photomask 700, the SEM 440 or the scanning probe microscope(s) and/or a gas injection system. This can be done for example by lowering the chuck 260 of the sample stage 100. A gas injection system, not illustrated in Fig. 4, can be used for example for providing one or more corresponding precursor gases at the location where an EBIE process or an EBID process is carried out.

In the next step, the reference points 720, 740, 760 of at least two of the three markings 710, 730, 750 of the rotated photomask 700 are measured again by means of the electron beam 450 of the SEM 440. The implementation of these measurements has been explained above in the context of the discussion of Figures 6 and 7. As likewise already explained above, during the determination of the reference points 720, 740, 760 of at least two of the three markings 710, 730, 750, no rotation through the rotation axis 250 of the sample stage 100 is permitted to be carried out. Furthermore, care should be taken to ensure that, between carrying out the rotational movement by means of the sample stage 100 and measuring the reference points 720, 740, 760 of the rotated photomask 700 by means of the electron beam 450 of the SEM 440, the device 400 does not carry out any tasks that may alter firstly the position of the sample stage 100 and secondly the position of the electron beam 450 of the SEM 400.

If a photomask 270, 410, 700 is arranged on the chuck 190, 260 such that its centre point lies exactly over the rotation axis 250 of the sample stage 100, a rotation of the photomask 270, 410, 700 through the rotation axis 250 of the sample stage 100 has the effect that the markings 710, 730, 750, just like the reference points 720, 740, 760 thereof, circulate on a known circular path around the rotation axis 250 of the sample stage 100. Generally, a photomask 270, 410, 700 fixed by the mask holder does not satisfy this condition, however, since in the general case the position of the rotation axis 250 and therefore the centre point of the circular path of the reference points 720, 740, 760 are not known.

As already explained above, a combined translational and rotational movement can be described by an affine transformation. Fig. 12 schematically elucidates a rotation of the photomask 700 with a rotation axis that is perpendicular to the surface of said photomask, by an arbitrary angle $\theta$. The coordinates of the reference points 720, 740 of the markings 710, 730 before carrying out the rotation are: $x_{1i}$, $y_{1i}$ and $x_{2i}$, $y_{2i}$, wherein the index "i" stands for the original coordinates of the reference points 720, 740 of the markings 710, 730. After the rotation, the reference points 720, 740 have the coordinates $x_{1r}$, $y_{1r}$ and $x_{2r}$, $y_{2r}$; in this case, the index "r" denotes the coordinates of the reference points 720, 740 of the markings 710, 730 after the rotation. As can be gathered from Fig. 12, the changes in the coordinates of the reference points 720, 740 can be expressed: $\Delta x_i = x_{2i} - x_{1i}$, $\Delta y_i = y_{2i} - y_{1i}$, $\Delta x_r = x_{2r} - x_{1r}$ and $\Delta y_r = y_{2r} - y_{1r}$. The following relationships additionally hold true: $\tan(\theta_i) = \Delta y_i/\Delta x_i$, $\tan(\theta_r) = \Delta y_r/\Delta x_r$ and $\theta = \theta_r - \theta_i$. Accordingly, the rotation angle $\theta$ can be determined from the measured reference points 720, 740 of the markings 710, 730.

The parameters $t_x$ and $t_y$ stand for a translation or displacement of the markings 710 and 730 that is induced by the rotation. The following thus results for the affine transformation describing the rotation:

$$\begin{bmatrix} x_r \\ y_r \\ 1 \end{bmatrix} = \begin{bmatrix} s \cdot \cos\theta & -s \cdot \sin\theta & t_x \\ s \cdot \sin\theta & s \cdot \cos\theta & t_y \\ 0 & 0 & 1 \end{bmatrix} \begin{bmatrix} x_i \\ y_i \\ 1 \end{bmatrix}$$

A rotation of the photomask by an angle $\theta$ should not bring about any scaling of the mask 700. The following can therefore be assumed for the parameter s to a good approximation: s = 1. A deviation when determining s that is greater than the error when ascertaining the other parameters therefore gives an indication of an error when determining the position of the rotation axis. For the translation parameters $t_x$ and $t_y$ the following results from the matrix equation above:

$$t_x = x_r - \cos\theta \cdot x_i + \sin\theta \cdot y_i$$

$$t_y = y_r - \sin\theta \cdot x_i - \cos\theta \cdot y_i$$

The aim then, is to find the coordinates $x_c$, $y_c$ of the rotation axis for which the following holds true:

$$x_r = x_i$$

$$y_r = y_i$$

The coordinates of the rotation axis are described by $x_c$, $y_c$, where "c" stands for centre. The markings 710, 730, 750 and respectively their reference points 720, 740, 760 move on a circular path around the rotation axis 250. If the sample stage 110 is then moved in the x- and y-directions such that the coordinates $x_c$, $y_c$ of the rotation axis 250 correspond to the coordinates of the point of incidence of the electron beam 450 of the SEM 440, then an image recorded by the SEM 440 rotates around the centre point thereof, i.e. the points of the SEM image have a pure rotational movement.

Apart from this special case, i.e. if the rotation axis 250 does not correspond to the axis of the electron beam 450, all points viewed by the SEM 440 during a rotation of the mask 700 experience a combined rotational and translational movement. If, for example, a defect with the coordinates $x_D$, $y_D$ lies within the region scanned by the electron beam 450 of the SEM 440, said defect normally migrates out of the scanned region or the field of view of the SEM during a rotation of the photomask 700 about the rotation axis 250. By means of a compensating translational movement of the sample stage 110 in the x- and y-directions, the defect $x_D$, $y_D$ can be displaced into the field of view or the scanned region of the SEM 440 again after the end of the rotation of the mask 700. The combination of a rotation of the sample stage 110 about the rotation axis 250 and a compensating translational movement of the sample stage 110 results in a rotation of the sample stage 110 around a defect $x_D$, $y_D$.

The origin of the coordinate system $x_c$, $y_c$, $z_c$ of the chuck surface 265 of the chuck 190, 260 is typically chosen such that the electron beam 450 of the SEM 440 lies at the coordinate origin.

After some conversions and using the conditions specified above for $x_i$, $x_r$ and $y_i$, $y_r$, it is possible to express the coordinates of the central rotation axis $x_c$, $y_c$ as a function of the translations $t_x$ and $t_y$ and of the rotation angle $\theta$:

$$x_c = -\frac{t_y\,(1+\cos\theta)}{2 \cdot \sin\theta} + \tfrac{1}{2}t_x$$

$$y_c = \frac{t_x \sin\theta}{2 - 2 \cdot \cos\theta} + \tfrac{1}{2}t_y$$

In this case, the translation parameters $t_x$ and $t_y$ are determined from the equations specified above, wherein the measured coordinates of the reference points 720, 740, 760 of the markings 710, 730 750 before and after the rotation are to be inserted into said equations.

If, after the parameters $t_x$, $t_y$ and $\theta$ have been determined, the sample stage 100 is displaced such that the rotation axis has the coordinates $x_c$, $y_c$, a rotation of the chuck 190, 260 does not result in a displacement of the scan region of the electron beam 450 of the SEM 440.

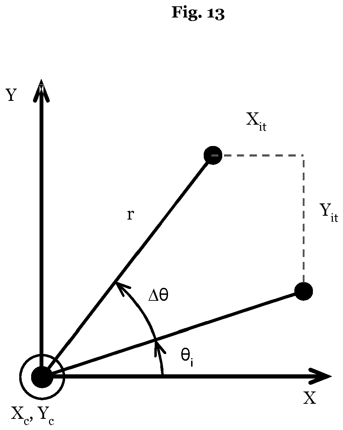

Fig. 13 illustrates a translation of a point $x_i$, $y_i$ by carrying out a rotation $\Delta\theta$ wherein the coordinates of the rotation axis do not correspond to the coordinates of the point of incidence of the electron beam 440 on the photomask 270, 410, 700. Therefore, as explained above, the rotation by $\Delta\theta$ additionally results in a displacement of the point $x_i$, $y_i$. This induced translation is identified by the indices "it". It can be expressed as a function of the original coordinates of the point $x_i$, $y_i$ and the rotation angle $\Delta\theta$:

$$x_{it} = (x_i - x_c) \cdot \cos\Delta\theta - (y_i - y_c) \cdot \sin\Delta\theta + x_c - x_i$$

$$y_{it} = (x_i - x_c) \cdot \sin\Delta\theta + (y_i - y_c) \cdot \cos\Delta\theta + y_c - y_i$$

In order to compensate for the translation caused by the rotation in relation to a scan region of the electron beam 450 of the SEM 440, the sample stage 100 has to be displaced in the opposite direction by the magnitude specified above.

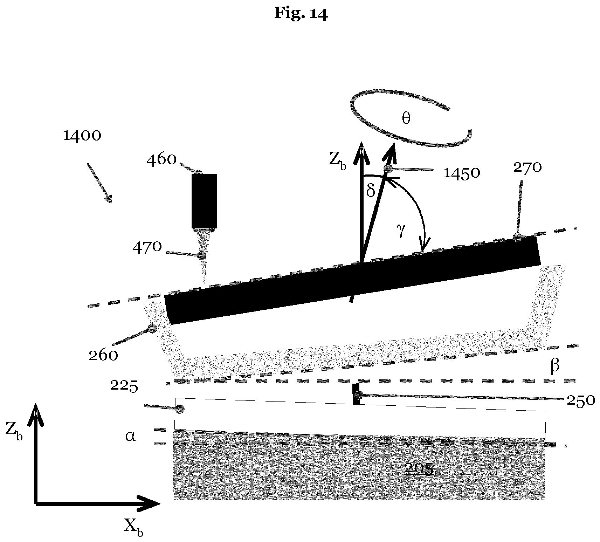

The diagram 1400 in Fig. 14 elucidates various possibly occurring deficiencies or defects of diverse components of the sample stage 100. As illustrated in Fig. 14, the second slide 225 of the sample stage 100, which moves the mask plate 190, 260 along the x-direction, can be tilted by an angle $\alpha$ relative to the baseplate 205 of the sample stage 100. Furthermore, the second slide 225 of the sample stage 100 can be rotated by an angle $\beta$ relative to the chuck 190, 260 or the mask plate 190, 260. These two inadequacies of the sample stage 100 result in an oblique or skew position of the photomask 270. A detailed explanation has already been given above of how a skew position of the photomask 270 can be ascertained and can be taken into account when carrying out translational movements of the sample stage 100.

However, an oblique position of the photomask 270 does not result in a wobble movement of the mask 270 as long as the rotation axis 1450 of the sample stage 100 is aligned perpendicularly to the mask 270, 410, 700 or to the top side 430 thereof. By contrast, an orientation of the rotation axis 1450 that deviates from the perpendicular to the photomask 270, 410, 700 results in a height change during the rotation of the mask 270, 410, 700 by the sample stage 100. A height change of the photomask 270, 410, 700 during the rotation is referred to hereinafter as a wobble movement of the mask 270, 410, 700.

Fig. 14 schematically shows that the rotation axis 1450 has an angle $\delta$ relative to the z-axis of the baseplate 205 of the sample stage 100. However, the angle deviation $\delta$ does not result in a wobble movement of the photomask 270, 410, 700 during the rotation thereof as long as the rotation axis 1450 is oriented perpendicularly with respect to the mask 270, 410, 700, i.e. $\gamma = 90°$ holds true. In the exemplary diagram 1400, the angle $\gamma$ measuring the angle between the surface 430 of the mask and the orientation of the rotation axis 1450 has a numerical value that deviates from 90°. The angle $\gamma \neq 90°$ results, however, in a height change during the rotation of the mask 270, 410, 700 about the rotation axis 1450, which height change is detected by the particle beam 470 of the height sensor 460.

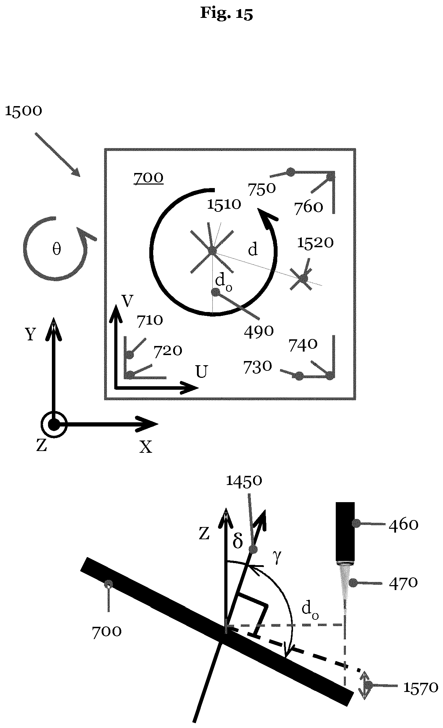

The diagram 1500 in Fig. 15 presents a plan view of the mask 700 in the upper partial image. The sample stage 100 has displaced the photomask 700 such that the coordinates 1510 of the rotation axis 1450 on the photomask 700 correspond to the coordinates of the point of incidence $x_c$, $y_c$ of the electron beam 450 of the SEM 440. The point of incidence of the particle beam 470 of the height sensor 460 is at a distance 490 or $d_o$ from the point of incidence of the electron beam 450 of the SEM 440. What is sought is the height change, the height profile or the wobble movement of the point 1520 if the rotation axis - as illustrated in the lower partial image in Fig. 15 - is not oriented perpendicularly to the photomask 700.

It is then assumed that, for the rotation angle indicated in Fig. 15, the height sensor 460 detects the maximum height change during the rotation of the photomask 700 about the rotation axis 1450. This rotation angle is therefore designated as $\theta_{max}$. For $\theta_{max} = \pm90°$, it then holds true that $\gamma = 90°$ and the height change as a result of the wobble movement vanishes. For $\theta_{max} = \pm180°$, the height change of the photomask 700 detected by the height sensor 460 reverses its sign.

From the lower partial image in Fig. 15, the following can be determined for the maximum height change, the

height change $\Delta h_{max}$ 1570 detected by the height sensor 460:

$$\Delta h_{max} = d_0 \cdot \tan(\delta + \gamma - 90°)$$

For the height profile $h(\theta, d_0)$ measured as a function of the rotation angle $\theta$ by the height sensor 460 during the rotation of the photomask 700 about the rotation axis 1450, the following therefore results:

$$h(\theta, d_0) = \cos(\theta - \theta_{max}) \cdot d_0 \cdot \tan(\delta + \gamma - 90°) + h_{off}$$

or:

$$h(\theta, d_0) = \Delta h_{max} \cdot \cos(\theta - \theta_{max}) + h_{off}$$

wherein the parameters $\theta_{max}$, $\Delta h_{max}$ and $h_{off}$ are initially unknown.

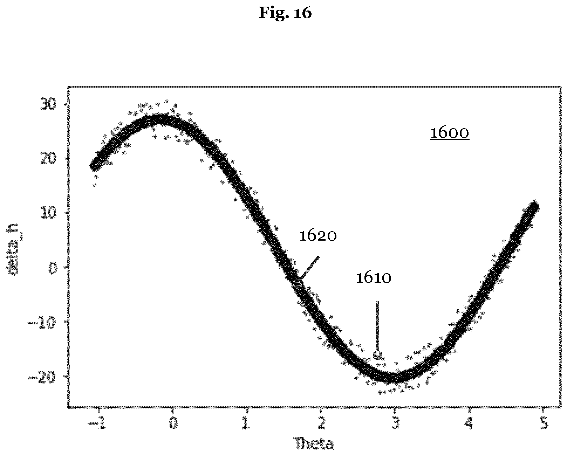

The diagram 1600 in Fig. 16 shows an example of the measured height profile $h(\theta, d_0)$ as a function of the rotation angle $\theta$ indicated in radian measure. The height change or the height profile is represented in micrometres. The points 1610 in Fig. 16 represent measurement points of the height sensor 460 during a rotation process. The solid curve 1620 represents a function fitted to the measurement points 1610. Numerical optimization algorithms, such as the Levenberg-Marquardt algorithm, for example, can be used for fitting the measurement points 1610. The parameters $\theta_{max}$, $\Delta h_{max}$ and $h_{off}$ are determined as a result of fitting the measurement data 1610 to the function indicated above.

The height change at an arbitrary point of the photomask 700, for instance at the point 1520, can be ascertained by means of a linear interpolation and/or a linear extrapolation of the height profile $h(\theta, d_0)$:

$$h(\theta, d) = h(\theta, d_0) \cdot \frac{d}{d_0}$$

wherein $h(\theta, d)$ describes the height profile of the photomask 700 as a function of the rotation angle $\theta$ and the distance d from the rotation axis.

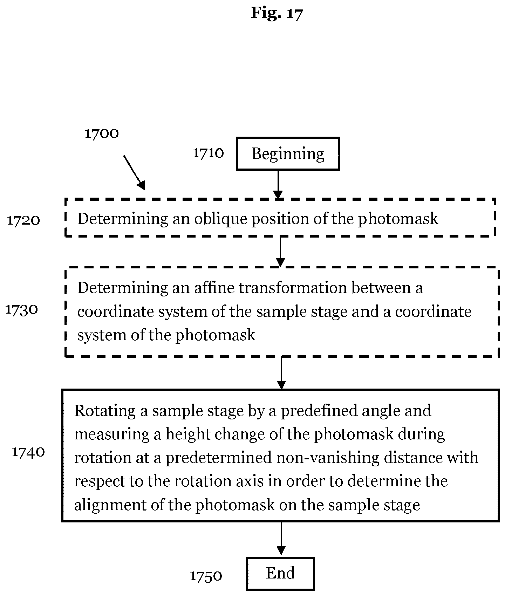

The flow diagram 1700 in Fig. 17 presents once again exemplary steps of the process of determining an alignment of a photomask 270, 410, 700 on a sample stage 100 which is displaceable along at least one axis that is parallel to a chuck surface 195, 265 of the sample stage 100, and is rotatable about at least one axis 250, 1450 that is perpendicular to the chuck surface 195, 265. The method begins in step 1710.

The next step 1720 involves determining an oblique position of the photomask 270, 410, 700. For this purpose, a height sensor 460 measures the z-coordinate of at least three points on the mask, wherein the three measurement points do not lie on a straight line.

Step 1730 involves determining the parameters of an affine transformation that combines the coordinate system of the sample stage 100 with the coordinate system of the photomask 270, 410, 700. For this purpose, the coordinates of at least two markings 710, 730, 750 of the photomask 270, 410, 700 are measured by means of a particle beam 450 of a particle beam source 440.

Both steps 1720 and 1730 are optional steps and are therefore represented with dashed boxes around them in Fig. 17.

In step 1740, the sample stage 100 is rotated by a predefined angle and the height change of the photomask 270, 410, 700 is measured during rotation at a non-vanishing distance with respect to the rotation axis 250, 1450 for the purpose of determining the alignment of the photomask 270, 410, 700.

The method ends in step 1750.

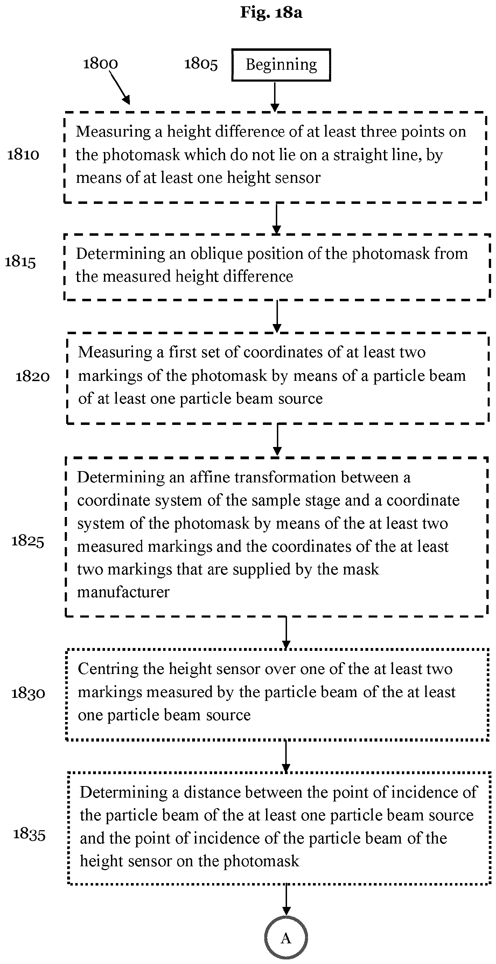

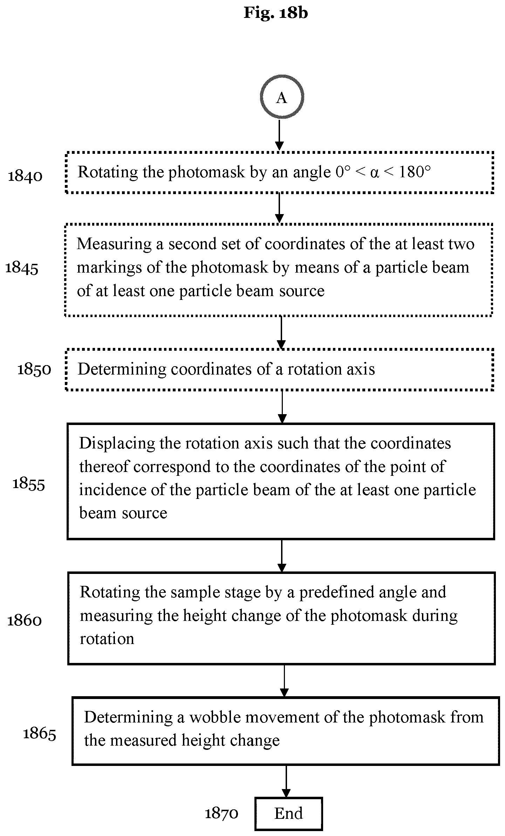

Finally, the flow diagram 1800 in Figures 18a and 18b reproduces the method explained in Fig. 17 in greater detail. The method begins in step 1805.

In the next step 1810, at least one height sensor 460 measures a height difference of at least three points on a photomask 270, 410, 700 which do not lie on a straight line. In step 1815, an oblique position of the photomask 270, 410, 700 is determined from the measured height difference.

Then, in step 1820, a first set of coordinates of at least two markings 710, 730, 750 of the photomask 270, 410, 700 are determined by means of a particle beam 450 of at least one particle beam source 440.

In step 1825, the parameters of an affine transformation that combines the coordinate system of the photomask 270, 410, 700 with the coordinate system of the sample stage 100 are determined on the basis of the first set of measured coordinates and the coordinates of the at least two markings 710, 730, 750 that are supplied by the mask manufacturer.

The four steps 1810 to 1825 are optional steps and are therefore illustrated with dashed boxes around them in Fig. 18.

In step 1830, the height sensor 460 is centred over one of the at least two markings 710, 730, 750 measured by means of the particle beam 450 of the at least one particle beam source 440. After that, in step 1835, the distance 490 between the point of incidence of the particle beam 450 of the at least one particle beam source 440 and the point of incidence of the particle beam 470 of the height sensor 460 is determined.

Steps 1830 and 1835 have to be carried out for example only if the distance 490 is not already known. This circumstance is illustrated by means of dotted boxes around the two optional steps.

In step 1840, the photomask 270, 410, 700 is rotated by an angle $0° < \alpha < 180°$. The rotation effected is preferably by an angle of 90°.

Then, in step 1845, a second set of coordinates of the at least two markings 710, 730, 750 of the photomask 270, 410, 700 is measured by means of the particle beam 450 of the at least one particle beam source 440. Afterwards, in step 1850, the coordinates of the rotation axis 1450 on the photomask 270, 410, 700 are determined.

Steps 1840 to 1855 are optional steps and are therefore illustrated with dotted boxes around them in Fig. 18. They may be carried out for example only if the position of the rotation axis 1450 on the photomask 270, 410, 700 is not known. This is the case for example if the coordinates of the particle beam 450 of the at least one particle beam source 440 in the coordinate system of the sample stage 100 are lost.

In step 1855, the rotation axis 1450 is optionally displaced with the aid of the sample stage 100 such that its coordinates correspond to the coordinates of the point of incidence of the particle beam 450 of the at least one particle beam source 440.

In the next step 1860, the sample stage 100 is rotated by a predefined angle and the height change $h(\theta, d_o)$ of the photomask 270, 410, 700 is measured during rotation.

Afterward, in step 1865, a wobble movement of the photomask can be determined from the measured height change $h(\theta, d_o)$. The method finally ends at 1870.

**Claims**

1. Method (1700, 1800) for determining an alignment of a photomask (270, 410, 700) on a sample stage (100) which is displaceable along at least one axis that is parallel to a chuck surface (195, 265) of the sample stage (100), and is rotatable about at least one axis (250) that is perpendicular to the chuck surface (195, 265), wherein the method (1700, 1800) comprises the following step:
   rotating the sample stage (100) by a predefined angle and measuring a height change (1570) of the photomask (270, 410, 700) during rotation at a predetermined, non-vanishing distance (490) with respect to the rotation axis (1450) for the purpose of determining the alignment of the photomask (270, 410, 700) on the sample stage (100).

2. Method (1700, 1800) according to the preceding claim, wherein the sample stage (100) is rotated by an angle that is greater than or equal to: 60°, preferably 90°, more preferably 180°, and most preferably 360°.

3. Method (1700, 1800) according to either of the preceding claims, wherein the method comprises the additional step of predetermining the non-vanishing distance with respect to the rotation axis (1450).

4. Method (1700, 1800) according to any of the preceding claims, wherein the method comprises the additional step of determining coordinates of the rotation axis (1450) on a surface (430) of the photomask (270, 410, 700).

5. Method (1700, 1800) according to the preceding claim, wherein determining the coordinates of the rotation axis (1450) comprises:

   a. measuring a first set of coordinates for at least two markings (710, 730, 750) of the photomask (270, 410, 700) by means of a particle beam (450) of a particle beam source (440), without rotating the photomask (270, 410, 700);
   b. rotating the photomask (270, 410, 700) by an angle $0° < \theta < 180°$ or $180° < \theta < 360°$; and
   c. measuring a second set of coordinates for the at least two markings (710, 730, 750) of the rotated photomask (270, 410, 700) by means of the particle beam (450) of the particle beam source (440).

6. Method (1700, 1800) according to any of Claims 3-5, wherein predetermining the non-vanishing distance with respect to the rotation axis (1450) comprises: determining coordinates of a point of incidence of a particle beam (470) of at least one height sensor (460) on the photomask (270, 410, 700).

7. Method (1700, 1800) according to any one of the preceding claims, wherein measuring the height change (1570) comprises: displacing the rotation axis (1450) under a point of incidence of a particle beam (450) of a particle beam source (440) on the photomask (270, 410, 700).

8. Method (1700, 1800) according to any of the preceding claims, furthermore comprising the following step: interpolating and/or extrapolating the measured height change (1570) of the photomask (270, 410, 700) for a value deviating from the predetermined, non-vanishing distance (490).

9. Method (1700, 1800) according to any of the preceding claims, furthermore comprising the following step: measuring a z-coordinate of the photomask (270, 410, 700) on the rotation axis (1450).

10. Method (1700, 1800) according to any of the preceding claims, wherein the sample stage (100) is displaceable along at least two axes that are parallel to the chuck surface (195, 265), and wherein the method furthermore comprises the following steps:

    a. measuring coordinates of at least two markings (710, 730, 750) of the photomask (270, 410, 700) by means of a particle beam (450) of a particle beam source (440), without rotating the photomask (270, 410, 700) with the sample stage (100); and
    b. determining an affine transformation between a coordinate system of the photomask (270, 410, 700) and a coordinate system of the sample stage (100) from the measured coordinates.

11. Method (1700, 1800) according to any of Claims 5-10, furthermore comprising the following step: determining an affine transformation between a coordinate system of the photomask and a coordinate system of the sample stage from the first set of coordinates.

12. Method (1700, 1800) according to Claim 10 or 11, wherein determining the affine transformation comprises: determining the parameters of a translation, a scaling and a rotation of the coordinate systems of the photomask and of the sample stage with respect to one another.

13. Method (1700, 1800) according to any of the preceding claims, wherein the sample stage (100) is displaceable along at least two axes that are parallel to a chuck surface (195, 265) of the sample stage (100), and wherein the method (1700, 1800) furthermore comprises the following step: measuring a height difference of at least three points on the photomask (270, 410, 700) that do not lie on a straight line by means of the at least one height sensor (460), without rotating the sample stage (100).

14. Device (400) for determining an alignment of a photomask (270, 410, 700) on a sample stage (100) which is displaceable along at least one axis that is parallel to a chuck surface (195, 265) of the sample stage (100), and is rotatable about at least one axis that is perpendicular to the chuck surface (195, 265), the device (400) comprising: at least one height sensor (460) configured for measuring a height change (1570) during rotation of the sample stage (100) by a predefined angle, wherein the at least one height sensor (460) is at a predetermined, non-vanishing distance (490) with respect to the rotation axis (1450), for the purpose of determining the alignment of the photomask (270, 410, 700) on the sample stage (100).

15. Computer program comprising instructions which, when they are executed by a computer system, cause the computer system to cause the device according to claim 14 to carry out the method steps according to any of claims 1 to 13.

**Patentansprüche**

1. Verfahren (1700, 1800) zum Bestimmen einer Ausrichtung einer Fotomaske (270, 410, 700) an einem Probengestell (100), das entlang mindestens einer Achse, die zu einer Spannfutteroberfläche (195, 265) des Probengestells (100) parallel ist, verfahrbar ist und um mindestens eine Achse (250), die zur Spannfutteroberfläche (195, 265) senkrecht ist, drehbar ist, wobei das Verfahren (1700, 1800) den folgenden Schritt umfasst:
Drehen des Probengestells (100) um einen vordefinierten Winkel und Messen einer Höhenänderung (1570) der Fotomaske (270, 410, 700) während der Drehung bei einer vorgegebenen nicht verschwindenden Entfernung (490) in Bezug auf die Drehachse (1450), um die Ausrichtung der Fotomaske (270, 410, 700) am Probengestell (100) zu bestimmen.

2. Verfahren (1700, 1800) nach dem vorhergehenden Anspruch, wobei das Probengestell (100) um einen Winkel gedreht wird, der größer oder gleich Folgendem ist: 60°, bevorzugt 90°, stärker bevorzugt 180° und am stärksten bevorzugt 360°.

3. Verfahren (1700, 1800) nach einem der vorhergehenden Ansprüche, wobei das Verfahren den zusätzlichen Schritt des Vorgebens der nicht verschwindenden Entfernung in Bezug auf die Drehachse (1450) umfasst.

4. Verfahren (1700, 1800) nach einem der vorhergehenden Ansprüche, wobei das Verfahren den zusätzlichen Schritt des Bestimmens von Koordinaten der Drehachse (1450) an einer Oberfläche (430) der Fotomaske (270, 410, 700) umfasst.

5. Verfahren (1700, 1800) nach dem vorhergehenden Anspruch, wobei das Bestimmen der Koordinaten der Drehachse (1450) Folgendes umfasst:

a. Messen eines ersten Satzes Koordinaten für mindestens zwei Markierungen (710, 730, 750) der Fotomaske (270, 410, 700) mittels eines Partikelstrahls (450) einer Partikelstrahlquelle (440), ohne die Fotomaske (270, 410, 700) zu drehen;
b. Drehen der Fotomaske (270, 410, 700) um einen Winkel $0° < \theta < 180°$ oder $180° < \theta < 360°$ und
c. Messen eines zweiten Satzes Koordinaten für die mindestens zwei Markierungen (710, 730, 750) der gedrehten Fotomaske (270, 410, 700) mittels des Partikelstrahls (450) der Partikelstrahlquelle (440).

6. Verfahren (1700, 1800) nach einem der Ansprüche 3-5, wobei das Vorgeben der nicht verschwindenden Entfernung in Bezug auf die Drehachse (1450) Folgendes umfasst: Bestimmen von Koordinaten eines Einfallspunkts eines Partikelstrahls (470) mindestens eines Höhensensors (460) an der Fotomaske (270, 410, 700).

7. Verfahren (1700, 1800) nach einem der vorhergehenden Ansprüche, wobei das Messen der Höhenänderung (1570) Folgendes umfasst: Verlagern der Drehachse (1450) unter einen Einfallspunkt eines Partikelstrahls (450) einer Partikelstrahlquelle (440) an der Fotomaske (270, 410, 700) .

8. Verfahren (1700, 1800) nach einem der vorhergehenden Ansprüche, das darüber hinaus den folgenden Schritt umfasst: Interpolieren und/oder Extrapolieren der gemessenen Höhenänderung (1570) der Fotomaske (270, 410, 700) für einen Wert, der von der vorgegeben nicht verschwindenden Entfernung (490) abweicht.

9. Verfahren (1700, 1800) nach einem der vorhergehenden Ansprüche, das darüber hinaus den folgenden Schritt umfasst: Messen einer z-Koordinate der Fotomaske (270, 410, 700) auf der Drehachse (1450).

10. Verfahren (1700, 1800) nach einem der vorhergehenden Ansprüche, wobei das Probengestell (100) entlang mindestens zwei Achsen, die parallel zur Spannfutteroberfläche (195, 265) sind, verfahrbar ist und das Verfahren darüber hinaus die folgenden Schritte umfasst:

a. Messen von Koordinaten von mindestens zwei Markierungen (710, 730, 750) der Fotomaske (270, 410, 700) mittels eines Partikelstrahls (450) einer Partikelstrahlquelle (440), ohne die Fotomaske (270, 410, 700) mit dem Probengestell (100) zu drehen; und
b. Bestimmen einer affinen Transformation zwischen einem Koordinatensystem der Fotomaske (270, 410, 700) und einem Koordinatensystem des Probengestells (100) aus den gemessenen Koordinaten.

11. Verfahren (1700, 1800) nach einem der Ansprüche 5-10, das darüber hinaus den folgenden Schritt umfasst: Bestimmen einer affinen Transformation zwischen einem Koordinatensystem der Fotomaske und einem Koordinatensystem des Probengestells aus dem ersten Satz von Koordinaten.

12. Verfahren (1700, 1800) nach Anspruch 10 oder 11, wobei das Bestimmen der affinen Transformation Folgendes umfasst: Bestimmen der Parameter eines Versatzes, einer Skalierung und einer Drehung der Koordinatensysteme der Fotomaske und des Probengestells in Bezug aufeinander.

13. Verfahren (1700, 1800) nach einem der vorhergehenden Ansprüche, wobei das Probengestell (100) entlang mindestens zwei Achsen, die zu einer Spannfutteroberfläche (195, 265) des Probengestells (100) parallel sind, verfahrbar ist und das Verfahren (1700, 1800) darüber hinaus den folgenden Schritt umfasst: Messen einer Höhendifferenz von mindestens drei Punkten an der Fotomaske (270, 410, 700), die nicht auf einer Gerade liegen, mittels des mindestens einen Höhensensors (460), ohne das Probengestell (100) zu drehen.

14. Vorrichtung (400) zum Bestimmen einer Ausrichtung einer Fotomaske (270, 410, 700) an einem Probengestell (100), das entlang mindestens einer Achse, die zu einer Spannfutteroberfläche (195, 265) des Probengestells (100) parallel ist, verfahrbar ist und um mindestens eine Achse, die zur Spannfutteroberfläche (195, 265) senkrecht ist, drehbar ist, wobei die Vorrichtung (400) Folgendes umfasst:
mindestens einen Höhensensor (460), der konfiguriert ist zum Messen einer Höhenänderung (1570) während der Drehung des Probengestells (100) um einen vordefinierten Winkel, wobei der mindestens eine Höhensensor (460) bei einer vorgegeben nicht verschwindenden Entfernung (490) in Bezug auf die Drehachse (1450) ist, um die Ausrichtung der Fotomaske (270, 410, 700) am Probengestell (100) zu bestimmen.

15. Computerprogramm, das Befehle umfasst, die, wenn sie durch ein Computersystem ausgeführt werden, das Computersystem veranlassen, zu verursachen, dass die Vorrichtung nach Anspruch 14 die Verfahrensschritte nach einem der Ansprüche 1 bis 13 ausführt.

**Revendications**

1. Procédé (1700, 1800) de détermination d'un alignement d'un photomasque (270, 410, 700) sur une platine porte-échantillon (100) qui est déplaçable le long d'au moins un axe qui est parallèle à une surface de mandrin (195, 265) de la platine porte-échantillon (100) et qui est rotative autour d'au moins un axe (250) qui est perpendiculaire à la surface de mandrin (195, 265), le procédé (1700, 1800) comprenant l'étape suivante :
rotation de la platine porte-échantillon (100) d'un angle prédéfini et mesure d'une variation de hauteur (1570) du photomasque (270, 410, 700) au cours de la rotation à une distance non nulle prédéterminée (490) par rapport à l'axe de rotation (1450), aux fins de déterminer l'alignement du photomasque (270, 410, 700) sur la platine porte-échantillon (100).

2. Procédé (1700, 1800) selon la revendication précédente, la platine porte-échantillon (100) subissant une rotation d'un angle supérieur ou égal à : 60°, de préférence 90°, de préférence encore 180°, et mieux encore 360°.

3. Procédé (1700, 1800) selon l'un ou l'autre des revendications précédentes, le procédé comprenant l'étape additionnelle de prédétermination de la distance non nulle par rapport à l'axe de rotation (1450).

4. Procédé (1700, 1800) selon l'une quelconque des revendications précédentes, le procédé comprenant l'étape additionnelle de détermination de coordonnées de l'axe de rotation (1450) sur une surface (430) du photomasque (270, 410, 700).

5. Procédé (1700, 1800) selon la revendication précédente, la détermination des coordonnées de l'axe de rotation (1450) comprenant :

   a. mesure d'un premier ensemble de coordonnées pour au moins deux repères (710, 730, 750) du photomasque (270, 410, 700) au moyen d'un faisceau de particules (450) d'une source de faisceau de particules (440), sans rotation du photomasque (270, 410, 700) ;
   b. rotation du photomasque (270, 410, 700) d'un angle $0° < \theta < 180°$ ou $180° < \theta < 360°$ ; et
   c. mesure d'un deuxième ensemble de coordonnées pour les au moins deux repères (710, 730, 750) du photomasque (270, 410, 700) après rotation, au moyen du faisceau de particules (450) de la source de faisceau de particules (440) .

6. Procédé (1700, 1800) selon l'une quelconque des revendications 3 à 5, la prédétermination de la distance non nulle par rapport à l'axe de rotation (1450) comprenant : la détermination de coordonnées d'un point d'incidence d'un faisceau de particules (470) d'au moins un capteur de hauteur (460) sur le photomasque (270, 410, 700) .

7. Procédé (1700, 1800) selon l'une quelconque des revendications précédentes, la mesure de la variation de hauteur (1570) comprenant : le déplacement de l'axe de rotation (1450) sous un point d'incidence d'un faisceau de particules (450) d'une source de faisceau de particules (440) sur le photomasque (270, 410, 700).

**8.** Procédé (1700, 1800) selon l'une quelconque des revendications précédentes, comprenant en outre l'étape suivante : interpolation et/ou extrapolation de la variation de hauteur (1570) mesurée du photomasque (270, 410, 700) pour une valeur s'écartant de la distance non nulle prédéterminée (490).

**9.** Procédé (1700, 1800) selon l'une quelconque des revendications précédentes, comprenant en outre l'étape suivante : mesure d'une coordonnée en z du photomasque (270, 410, 700) sur l'axe de rotation (1450).

**10.** Procédé (1700, 1800) selon l'une quelconque des revendications précédentes, la platine porte-échantillon (100) étant déplaçable le long d'au moins deux axes qui sont parallèles à la surface de mandrin (195, 265), et le procédé comprenant en outre les étapes suivantes :

    a. mesure de coordonnées d'au moins deux repères (710, 730, 750) du photomasque (270, 410, 700) au moyen d'un faisceau de particules (450) d'une source de faisceau de particules (440), sans rotation du photomasque (270, 410, 700) avec la platine porte-échantillon (100) ; et

    b. détermination d'une transformation affine entre un système de coordonnées du photomasque (270, 410, 700) et un système de coordonnées de la platine porte-échantillon (100) à partir des coordonnées mesurées.

**11.** Procédé (1700, 1800) selon l'une quelconque des revendications 5 à 10, comprenant en outre l'étape suivante : détermination d'une transformation affine entre un système de coordonnées du photomasque et un système de coordonnées de la platine porte-échantillon à partir du premier ensemble de coordonnées.

**12.** Procédé (1700, 1800) selon la revendication 10 ou 11, la détermination de la transformation affine comprenant : la détermination des paramètres d'une translation, d'une mise à l'échelle et d'une rotation des systèmes de coordonnées du photomasque et de la platine porte-échantillon l'un par rapport à l'autre.

**13.** Procédé (1700, 1800) selon l'une quelconque des revendications précédentes, la platine porte-échantillon (100) étant déplaçable le long d'au moins deux axes qui sont parallèles à une surface de mandrin (195, 265) de la platine porte-échantillon (100), et le procédé (1700, 1800) comprenant en outre l'étape suivante : mesure d'une différence de hauteur d'au moins trois points sur le photomasque (270, 410, 470) qui ne se trouvent pas sur une ligne droite au moyen de l'au moins un capteur de hauteur (460), sans rotation de la platine porte-échantillon (100).

**14.** Dispositif (400) de détermination d'un alignement d'un photomasque (270, 410, 700) sur une platine porte-échantillon (100) qui est déplaçable le long d'au moins un axe qui est parallèle à une surface de mandrin (195, 265) de la platine porte-échantillon (100) et qui est rotative autour d'au moins un axe qui est perpendiculaire à la surface de mandrin (195, 265), le dispositif (400) comprenant :
au moins un capteur de hauteur (460) configuré pour mesurer une variation de hauteur (1570) au cours de la rotation de la platine porte-échantillon (100) d'un angle prédéfini, l'au moins un capteur de hauteur (460) se situant à une distance non nulle prédéterminée (490) par rapport à l'axe de rotation (1450), aux fins de déterminer l'alignement du photomasque (270, 410, 700) sur la platine porte-échantillon (100).

**15.** Programme informatique comprenant des instructions qui, lorsqu'elles sont exécutées par un système informatique, amènent le système informatique à faire réaliser, par le dispositif selon la revendication 14, les étapes de procédé selon l'une quelconque des revendications 1 à 13.

**Fig. 1**

**Fig. 2**

**Fig. 3**

300

| Mask coordinates: u, v, w, $\theta$ | 370 |

↕ 360

| Coordinates of the chuck surface: $x_{ch}$, $y_{ch}$, $z_{ch}$, $\theta$ | 350 |

↕ 340

| Coordinates at the top side of the upper plate: $x_w$, $y_w$, $z_w$ | 330 |

↕ 320

| Coordinates of the baseplate of the sample stage: $x_b$, $y_b$, $z_b$ | 310 |

**Fig. 4**

**Fig. 5**

**Fig. 6**

**Fig. 7**

Fig. 8

**Fig. 9a**

900

905 — Beginning

910 — First diagonal scan

915 — Analyzing the first scan in order to determine $d_1$

920 — Moving the sample stage 90° with respect to the scan direction

925 — Second diagonal scan

930 — Analyzing the second scan in order to determine $d_2$

A

**Fig. 9b**

Fig. 10

**Fig. 11**

**Fig. 12**

**Fig. 13**

**Fig. 14**

**Fig. 15**

**Fig. 16**

**Fig. 17**

1700

1710 | Beginning

1720 — Determining an oblique position of the photomask

1730 — Determining an affine transformation between a coordinate system of the sample stage and a coordinate system of the photomask

1740 — Rotating a sample stage by a predefined angle and measuring a height change of the photomask during rotation at a predetermined non-vanishing distance with respect to the rotation axis in order to determine the alignment of the photomask on the sample stage

1750 | End

## Fig. 18a

1800        1805   | Beginning |

1810 — Measuring a height difference of at least three points on the photomask which do not lie on a straight line, by means of at least one height sensor

1815 — Determining an oblique position of the photomask from the measured height difference

1820 — Measuring a first set of coordinates of at least two markings of the photomask by means of a particle beam of at least one particle beam source

1825 — Determining an affine transformation between a coordinate system of the sample stage and a coordinate system of the photomask by means of the at least two measured markings and the coordinates of the at least two markings that are supplied by the mask manufacturer

1830 — Centring the height sensor over one of the at least two markings measured by the particle beam of the at least one particle beam source

1835 — Determining a distance between the point of incidence of the particle beam of the at least one particle beam source and the point of incidence of the particle beam of the height sensor on the photomask

( A )

**Fig. 18b**

A

1840 Rotating the photomask by an angle $0° < \alpha < 180°$

1845 Measuring a second set of coordinates of the at least two markings of the photomask by means of a particle beam of at least one particle beam source

1850 Determining coordinates of a rotation axis

1855 Displacing the rotation axis such that the coordinates thereof correspond to the coordinates of the point of incidence of the particle beam of the at least one particle beam source

1860 Rotating the sample stage by a predefined angle and measuring the height change of the photomask during rotation

1865 Determining a wobble movement of the photomask from the measured height change

1870 End

**EP 4 168 859 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102020209638
- US 2019095740 A1
- US 2005285033 A1
- US 5672885 A